(19) Europäisches Patentamt
European Patent Office
Office européen des brevets

(11) **EP 1 800 346 B1**

(12) **EUROPEAN PATENT SPECIFICATION**

(45) Date of publication and mention
of the grant of the patent:
**25.01.2012 Bulletin 2012/04**

(51) Int Cl.:
*H01L 29/778* (2006.01)    *H01L 29/15* (2006.01)
*H01L 29/20* (2006.01)

(21) Application number: **05784616.4**

(86) International application number:
**PCT/EP2005/054559**

(22) Date of filing: **13.09.2005**

(87) International publication number:
**WO 2006/030014 (23.03.2006 Gazette 2006/12)**

(54) **HEMT PIEZOELECTRIC STRUCTURES WITH ZERO ALLOY DISORDER**

PIEZOELEKTRISCHE HEMT-STRUKTUREN MIT NULLLEGIERUNGSUNORDNUNG

STRUCTURES PIEZO-ELECTRIQUES DE TYPE HEMT A ZERO DESORDRE D'ALLIAGE

(84) Designated Contracting States:
**AT BE BG CH CY CZ DE DK EE ES FI FR GB GR HU IE IS IT LI LT LU LV MC NL PL PT RO SE SI SK TR**

(30) Priority: **13.09.2004 FR 0409674**
**31.03.2005 FR 0503173**

(43) Date of publication of application:
**27.06.2007 Bulletin 2007/26**

(73) Proprietor: **PICOGIGA INTERNATIONAL**
**38190 Bernin (FR)**

(72) Inventors:
• **LAHRECHE, Hacène**
**F-75014 Paris (FR)**
• **BOVE, Phillipe**
**F-91190 Gif S/Yvette (FR)**

(74) Representative: **Collin, Jérôme et al**
**Cabinet Regimbeau**
**20, rue de Chazelles**
**75847 Paris Cedex 17 (FR)**

(56) References cited:
WO-A-02/093650     WO-A-03/050849
WO-A-2004/066393   US-A- 5 192 987
US-A- 5 844 260    US-A- 6 100 542

**Description**

This invention relates to manufacturing of semiconducting substrates for use in making electronic components.

The technical domain of the invention may be defined in general as preparation of layers of semiconducting materials based on nitride on a support.

General presentation of prior art

Semiconducting materials based on nitrides of III elements in the periodic table occupy an increasingly important place in the electronic and optoelectronic fields.

These materials intended for manufacturing of HEMT (High Electron Mobility Transistors) are used to make electronic circuits dedicated to high frequency and high power applications.

Such materials based on nitrides of III elements present a number of advantages - as an illustration, they do not require doping the material contrary to what is known in materials such as materials based on arsenide.

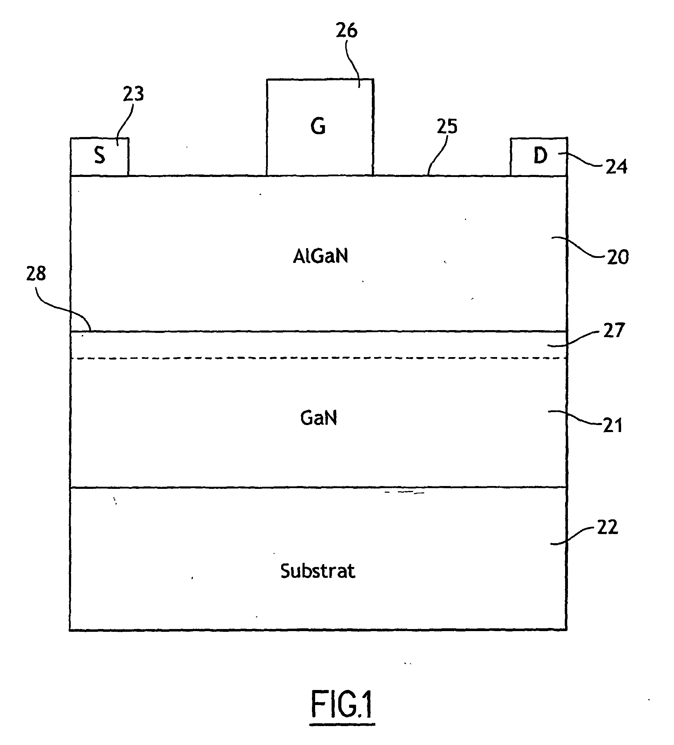

An example HEMT made on a semiconducting material based on III-N, or nitrides of III elements ( (In, Ga, Al) /N) is shown in Figure 1.

The material includes a barrier layer 20 made of Gallium and Aluminium nitride (AlGaN) developed on a channel layer 21 made of Gallium nitride (GaN), itself developed on a support 22.

The HEMT transistor also comprises a source electrode 23 and a drain electrode 24 on the front face 25 of the barrier layer 20 of AlGaN, and a grid electrode 26 between the source electrode 23 and the drain electrode 24.

Due to the presence of Aluminium in the AlGaN barrier layer 20, the barrier layer has a wider prohibited energy band than the channel layer 21 of GaN. Silicon impurities in the AlGaN barrier layer 20 supply electrons to the crystal that tend to accumulate in a region 27 with the lowest potential (a quantum well) just under the interface 28 between the_AlGaN barrier layer 20 and the GaN channel layer 21.

This forms a sheet of electrons 27 that forms a two-dimensional electron gas (2 DEG). The mobility of electrons in this gas is high since they are physically separated from silicon atoms residing in the AlGaN barrier layer 20.

Although the first studies on semiconducting materials based on III-N were carried out in the 1970s, the real advantage of this type of material only became clear after p type conduction was obtained in a GaN channel layer followed by marketing of blue diodes by Nichia Chemicals [1].

Devices based on AlGaN/GaN structures with two-dimensional electron gases [9, 11] now have much better characteristics than the corresponding products in other material 1 systems [6, 7].

Semiconducting materials based on III-N form a very innovative semiconductor system with the following specific features:

- a prohibited band width varying from 0.8 eV to 6.2 eV,
- the possibility of making continuous alloys of AlGaN, thus enabling the production of heterostructures with a large degree of freedom,
- a very weak crystalline mesh parameter mismatch between gallium nitride (GaN) and Aluminium nitride (AlN), so that complex structures can be made without creation of crystalline defects:

$$\Delta a/a \; = \; (a_{GaN} - a_{AlN}/a_{GaN} \; = \; 1\%$$

where:

- $a_{GaN}$ is the mesh parameter of GaN,
- $a_{AlN}$ is the mesh parameter of AlN,
- $\Delta a/a$ is the mesh parameter mismatch (a mesh parameter mismatch less than or equal to 1% is the sign of a quasi pseudomorphic coherent growth),

- excellent electronic properties (good mobility of electrons, high saturation speed, high breakdown field),
- excellent thermal and chemical stability,
- good thermal properties (dissipation of heat),
- the presence of a strong polarization field to obtain large charge transfers in two-dimensional electron gases (2 DEG).

Therefore, semiconducting materials based on III-N have better performance than semiconducting materials based on "classical" III-V, particularly concerning the mobility of charge carriers and the charge density.

Mobility of charge carriers

From the point of view of production of the material, mobility and the current density per unit surface area of AlGaN/GaN structures will be governed by four preponderant parameters:

- the defect density in the layers [18],
- the surface roughness (RMS) and the chemical roughness at the AlGaN/GaN interface (alloy disorder in the AlGaN barrier layer) [19, 20],
- the distance from the electron gas (2 DEG) to the interface, that can be modulated by inserting a spacer (undoped potential barrier) to limit diffusion of electrons at the interface [21],
- the state of strain in the HEMT structure (in the AlGaN and GaN layers) that has an influence on the piezo-electric field [22] (there is also an intense spontaneous polarisation field in wurtzite heterostructures [23] that participate in the charge transfer).

Charge density

Exceptional charge transfers observed in AlGaN/GaN structures ($n_s \sim 1020 - 3 \times 10^{13}$ cm$^{-2}$) are induced by a particular polarisation field: the piezoelectric polarisation field. This is also referred to piezo induced High Electron Mobility Transistor (Piezo-HEMT).

AlGaN/GaN structures have a Wurtzite type hexagonal structure. Piezo-electric polarisation originates from non-centrosymmetry of this Wurtzite structure.

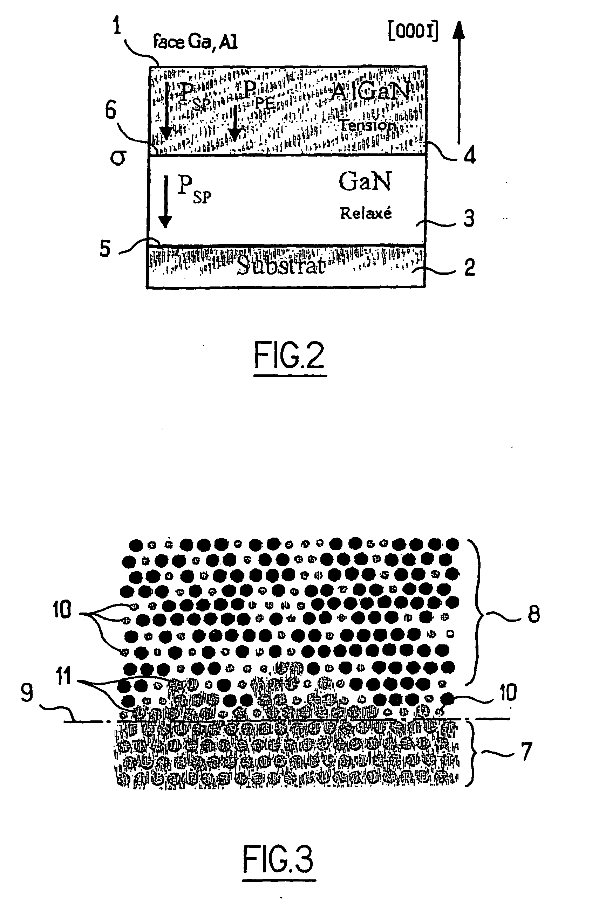

There are several models that describe the piezo-electric polarisation phenomenon. The simplest is the Ambacher et al. model [22] that is briefly summarized below with reference to Figure 2. Starting from this model, it is possible to determine what material parameters have an influence on the charge density of transistor structures made on III-N based semiconducting materials.

A substrate comprising a Ga (Al) layer in the front face 1 or growth face is shown in Figure 2.

This substrate comprises a support 2, a GaN channel layer 3, and an AlGaN barrier layer 4. The support 2 is a semiconducting or non-semiconducting material. For example, the support 2 may be made of SiC or Si. The GaN channel layer 3 is deposited on the front face 5 of the support 2. This GaN channel layer 3 is relaxed. The AlGaN barrier layer 4 is located on the front face 6 of the GaN channel layer 3. This AlGaN barrier layer 4 is strained. The AlGaN barrier layer 4 is an $Al_xGa_{1-x}N$ type alloy where x represents the molar fraction of the $Al_xGa_{1-x}N$ alloy.

If there is no external electric field, the total polarisation field P of an $Al_xGa_{1-x}N$/GaN structure along an axis [0001] is equal to the sum of a spontaneous polarisation field $P_{SP}$ and a piezoelectric polarisation field $P_{PE}$ induced by strain in the $Al_xGa_{1-x}N$ barrier layer 4.

The spontaneous polarisation field $P_{SP}$ (X)[23] in the $Al_xGa_{1-x}N$ barrier layer 4 is expressed as a function of spontaneous polarisation constants of Gallium nitride (GaN) and Aluminium nitride (AIN), assuming a linear variation:

$$P_{SP}(x) = -0.52x - 0.029 \ C/m^2 \quad (I)$$

where x represents the molar fraction of the $Al_xGa_{1-x}N$ alloy.

The sign of the spontaneous polarisation field $P_{SP}$ will depend on the polarity of the crystal. In the classical case of a substrate 1 comprising a Gallium layer (Aluminium, Indium) in front face (growth face), the spontaneous polarisation field $P_{SP}$ is negative (in other words is opposite to the growth axis [0001]. Therefore the spontaneous polarisation field $P_{SP}$ points from the growth face 1. towards the support 2.

The piezo-electric polarisation field $P_{PE}$ (X) in the $Al_xGa_{1-x}N$ barrier layer 4 is expressed as a function of piezoelectric constants $e_{33}$ (x) and $e_{31}$ (x) of the alloy $Al_xGa_{1-x}N$:

$$P_{PE}(x) = e_{33}(x)\in_{zz} + e_{31}(x)(\in_{xx}+\in_{yy}) \quad (2)$$

where:

- x represents the molar fraction of the alloy $Al_xGa_{1-x}N$,
- $e_{33}$ (x) and $e_{13}$ (x) are the piezo-electric constants of the $Al_xGa_{1-x}N$ alloy,
- $\in_{xx}$, $\in_{yy}$ and $\in_{zz}$ represent deformations of the length, width and height of the $Al_xGa_{1-x}N$ alloy.

The piezoelectric constants $e_{33}(x)$ and $e_{13}(x)$ of the $Al_xGa_{1-x}N$ are calculated from the piezoelectric constants $e_{33}$ and $e_{13}$ of GaN and the piezoelectric constant $e_{33}$ and $e_{13}$ of AlN.

As an example, a table giving the piezoelectric constants of GaN and of AlN is:

*Table II: piezoelectric constants of GaN and AlN [23]*

| Material | $P_{SP.}$ (C/m$^2$) | $e_{33}$ (C/m$^2$) | $e_{31}$ (C/m$^2$) |
|---|---|---|---|
| AlN | - 0.081 | 1.46 | -0.60 |
| GaN | -0.029 | 0.73 | -0.49 |

If the deformations $\in_{1J}$ are developed in equation (2) as a function of the elastic constants Cij(x) of the $Al_xGa_{1-x}N$ alloy and the mesh parameters of the GaN channel layer and the $Al_xGa_{1-x}N$ barrier layer, the result is:

$$P_{PE}(x) = 2\frac{a(x)-a_0}{a_0}(e_{31}(x)-e_{33}(x)\frac{C_{13}(x)}{C_{33}(x)}) \qquad (3)$$

where:

- so represents the mesh parameter of GaN,
- a(x) represents the mesh parameter of the $Al_xGa_{1-x}N$ alloy,
- $C_{13}(x)$ and $C_{33}(x)$ represent the elastic constants of the $Al_xGa_{1-x}N$ alloy.

The elastic constants $C_{13}(x)$ and $C_{33}(x)$ of the $Al_xGa_{1-x}N$ alloy are calculated starting from elastic constants $C_{13}$ and $C_{33}$ of GaN and AlN assuming a linear variation as a function of x. The values of the elastic constants $C_{13}$ and $C_{33}$ of GaN and AlN commonly used in the literature are as given by Wright et al. These values agree well with experimental data, particularly data by Polian et al. for GaN.

As an example, a table giving the elastic constants of GaN and of AlN is:

*Table III: Elastic constants of GaN and AlN*

| Material | $C_{13}$ | $C_{33}$ | Reference |
|---|---|---|---|
| AlN | 108 | 373 | *Wright et al.* |
| GaN | 103 | 405 | *Wright et al.* |

In equation (3), the quantity "$e_{31}(x)-e_{33}(x) \times (C_{13}(x)/C_{33}(x))$" is negative for the entire composition range. Consequently, the piezo-electric polarisation $P_{PE}(x)$ will be negative for the barrier layer of $Al_xGa_{1-x}N$ 4 strained in tension.

The polarisation discontinuity at the $Al_xGa_{1-x}N$/GaN interface 6 between the barrier layer of $Al_xGa_{1-x}N$ and the channel layer of GaN generates a positive charge distribution at the $Al_xGa_{1-x}N$/GaN interface 6, for which the density is written as follows:

$$\sigma = P(AlGaN) - P(GaN)$$

$$\sigma = P_{SP}(AlGaN - P_{PE}(AlGaN) - P_{SP}(GaN) \qquad (4)$$

Equations (1), (3) and (4) are used to calculate the charge density $\sigma/e$ (where $e = 1.6 \times 1.0^{-19}$ C) for strained structures.

If the Aluminium content in the $Al_xGa_{1-x}N$ barrier layer is between 5% and 30%, the charge density induced by the polarisation is between $2 \times 10^{12}$ cm$^{-2}$ and $2 \times 10^{13}$ cm$^{-2}$.

In order to compensate for this high positive charge, a two-dimensional electron gas will be formed at the $Al_xGa_{1-x}N$/GaN interface 6. Therefore, there is an additional contribution to that induced by the band structure.

The simple model by Ambacher et al described above demonstrates dependence between the charge density induced by polarisation and the concentration of Aluminium in the $Al_xGa_{1-x}N$ barrier layer 4.

Thus, the charge carrier mobility and charge density properties of transistor structures obtained starting from a III-N-based semiconducting material depend on parameters such as the chemical roughness at the AlGaN/GaN interface and the Aluminium concentration in the AlGaN barrier. These parameters are related to methods of producing the semiconducting material based on III-N, and generate problems with the reliability of transistor structures made on said semiconducting material.

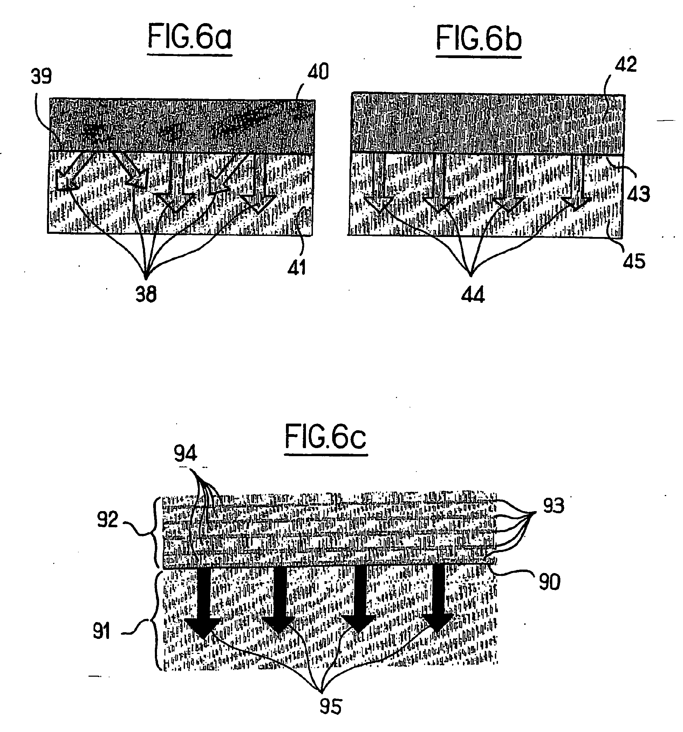

Figure 6a is a sectional view illustrating a semiconducting material of the prior art based on III-N. This material comprises a classical barrier layer 40 on a channel layer 41.

A drawback of the semi-conducting material of the prior art is the non-homogeneous distribution of Ga and Al atoms in the barrier layer 40. This is due in particular to the difference in behaviour of Ga and Al in terms of diffusion capacity, and to segregation effects which follow this difference in behaviour.

This non homogeneous distribution of Ga and Al atoms in the barrier layer 40 induces non-homogeneity of the piezoelectric field 38 at the interface 39 between the channel layer 41 and the barrier layer 40. Indeed, the direction and the intensity of the piezoelectric field locally depend on the distribution of Ga and Al atoms in the barrier layer 40.

The non-homogeneity of the piezoelectric field induces fluctuations in the electronic density at this interface 39. As a consequence, the power output by a transistor structure made on the semi-conducting material comprising this AlGaN barrier layer will be distributed non-homogeneously.

Moreover, the non-homogeneous distribution of Ga and Al atoms induces non-homogeneity of the electron distribution (particularly in the channel layer).

Document WO02/093650 describes a process for making a semi-conducting structure comprising a barrier layer including an alternation of layers of GaN and AlN, each layer of AlN and GaN being in the range of 5 to 20 Angstrom thick.

As will be apparent when reading the description of the present invention, an embodiment of WO02/093650 thus shares with the present invention alternating layers of binary materials for making a larger layer of material.

The process disclosed in WO02/093650 allows increasing the electron mobility within the structure.

However, WO02/093650 does not address the issue of increasing the homogeneity of the electron distribution (particularly in the channel layer).

And in this respect the process disclosed by WO02/093650 does not provide a solution for increasing the homogeneity of the electron distribution in the layers of the structure. It will be appreciated that this known process does not suggest a solution as provided by the invention, which specifically addresses the issue of homogeneity and which provides specific means to treat this issue.

Moreover, WO002/093650 does not allow increasing homogeneity of the piezoelectric field at the interface between the barrier layer and the channel layer and thus does not allow limiting the fluctuations in the electronic density at this interface.

It can also be noted that other processes disclose alternating elementary layers of different materials for making a larger layer.

And some of these known processes even disclose selecting very thin elementary layers - which is an advantageous feature of the invention. Reference is made in this respect to US6100542. However, a known process such as the one disclosed in US6100542 does not address layers of materials based on nitrides, but materials based on arsenide.

It thus appears that the existing processes for making structures with layers based on nitrides are associated to some limitations. It is a general object of the invention to address these limitations.

And more precisely, an aim of the present invention is to increase the homogeneity of the electron distribution, particularly in the channel layer.

Another aim of the invention is to increase the homogeneity of the piezoelectric field at the interface between the barrier layer and the channel layer and thus to homogenise the electronic density at this interface.

Another aim of the invention is to improve the electronic properties of semi-conducting materials based on III-N, particularly by improving methods of producing the semi-conducting material based on III-N.

Summary of the invention

The invention relates to a semiconducting substrate based on elements in columns III and V in the periodic table, to be used for example for manufacturing of HEMT of HEMT type transistor structures, comprising a support, a channel layer on the support and a barrier layer on the channel layer,
wherein the barrier layer is composed of an alternation of layers composed of at least one atomic monolayer of first and second III-N binary semi-conducting alloys, each atomic monolayer being composed of one monoatomic plane of III element and one monoatomic plane of nitrogen.

Thus, and as will become clearer in the following, the alternation of layers of binary alloys in the barrier layer has the following advantages:

- a reduced alloy disorder at the atomic scale,
- zero alloy non-homogeneities at the nanometric scale and at the microscopic scale,

- a perfect alloy order according to a privileged crystalline axis,
- a maximum piezoelectric field along a preferred crystalline axis,
- an optimum electron piezoelectric injection,
- a very uniform electronic density per unit surface area,
- a reduced electronic diffusion at interfaces and in the barrier layer due to the reduced alloy disorder,
- improved structure reliability due to the absence of any alloy non-homogeneities.

Indeed, by improving the distribution of Ga and Al atoms in the barrier layer, it allows increasing the homogeneity of the electron distribution. It also allows increasing the homogeneity of the piezoelectric field at the interface between the barrier layer and the channel layer, and thus to homogenise the electronic density at this interface.

More particularly, by limiting the parameters:

- of roughness at the interface between the channel layer and the barrier layer,
- of non-homogeneity of the Aluminium concentration in the barrier layer, and
- of non homogeneity of Gallium concentration in the channel layer,

it allows increasing the homogeneity of the piezoelectric field as described above.

Furthermore, it will be understood in the following that when a layer A is mentioned as being "on" a layer B, it may be directly on layer B, or it may be located above layer B and separated from said layer B by one or several intermediate layers.

It will also be understood that when a layer A is said to be "on" a layer B, it may cover the entire surface of the layer B, or a portion of said layer B.

Preferred non-limitative aspects of the semiconductor according to the invention are as follows:

- the channel layer comprises an alternation, at the atomic scale, of layers of third and fourth III-V binary semi-conducting alloys
- the semi-conducting substrate further includes a buffer layer between the support and the channel layer, the buffer layer comprising an alternation, at the atomic scale, of layers of fifth and sixth III-V binary semi-conducting alloys;
- the number of atomic monolayers in each binary alloy of the alternation of the barrier layer or of the channel layer or of the buffer layer is comprised between 1 and 20;
- the number of atomic monolayers in each binary alloy of the alternation of the barrier layer or of the channel layer or of the buffer layer varies between a first value on a back face of the barrier layer or of the channel layer or of the buffer layer, and a second value on a front face of the barrier layer or of the channel layer or of the buffer layer, the back face being closer to the support than the front face;
- the first and second values are comprised between 1 and 20;
- the first, second, third, fourth, fifth an sixth binary alloys are chosen from among AlN, GaN, 13N, and InN;
- the barrier layer further includes a layer of III-V semi-conducting ternary alloy;
- the alternation, at the atomic scale, of layers of first and second III-V semi-conducting binary alloys is located between the support and said layer of III-V semi-conducting ternary alloy;
- the barrier layer comprises a plurality of layers of III-V semi-conducting ternary alloy, each layer of III-V semi-conducting ternary alloy being located between a layer of the first binary alloy and a layer of the second binary alloy of the alternation;
- the barrier layer further includes a layer of the III-V semi-conducting ternary alloy on the alternation, at the atomic scale, of layers of first and second III-V semi-conducting binary alloys;
- the channel layer further comprises a plurality of layers of III-V semi-conducting ternary alloy, each layer of III-V semi-conducting ternary alloy being located between a layer of the third binary alloy and a layer of the fourth binary alloy of the alternation;
- the number or atomic monolayers in each layer of the ternary alloy located between two layers of the binary alloys is comprised between 1 and 5;
- the channel layer is made of a layer of ternary alloy of AlGaN, or InGaN, or AlBN, or InBN, or InAlN;
- the channel layer is made of a layer of binary alloy of GaN, or Aln, or BN, or InN;
- the semi-conducting substrate further comprises a buffer layer between the support and the channel layer, the buffer layer being made of a layer of binary alloy of GaN, or AlN, or BN, or InN;
- the semi-conducting substrate further comprises a buffer layer between the support and the channel layer, the buffer layer being made of a layer of ternary alloy of AlGaN, or origan, or AlBN, or InBN, or InAlN
- the support is made of a material chosen from among Si, SiC, AlN, Sapphire, and GaN;
- the thickness of the barrier layer (53) is comprise between 2nm and 500 nm.

The invention also relates to a method for preparation of a semi-conducting substrate comprising a support, a channel layer on the support and a barrier layer on the channel layer, wherein the methods comprises the following step (no order being imposed):

    a. creation of an initial barrier layer by:

        i) deposit of at least one atomic monolayer of a first binary alloy;
        ii) deposit of at least one atomic monolayer of a second binary alloy;
        iii) repetition of steps i) and ii) if necessary until the required thickness is obtained.

One aspect of the above method is that the semi-conducting substrate is that it is obtained by individually fitting monolayers of AlN binary alloy and monolayers of GaN binary alloy in order to obtain a barrier layer as homogeneous as possible. In this respect it is important to notice that the invention addresses the structure at the detailed scale of the monolayer, and an accurate definition of a "monolayer" shall be provided further in this text.

Preferred but non-limitative aspects of the method according to the invention are as follows:

- the method further comprises the step of creation of at least one layer of ternary alloy in or on the initial barrier layer;
- the step of creation of said layer of ternary alloy comprises the deposit of a layer of a ternary alloy;
- the step of creation of said layer of ternary alloy comprises thermal treatment of atomic monolayers of first and second binary alloys deposited in i) and ii);
- the thermal treatment is carried out after at least some deposits of the second binary alloy:

    - at a surface temperature between 0°C and 300°C above to the temperature of creation of monolayers of first and second binary alloys;
    - under vacuum or ultra-high vacuum between $10^{-8}$ Torr and $10^{-1}$ Torr ;
    - under a gas mixture flow comprising ammoniac NH3 or nitrogen molecule N2 or hydrogen molecule H2 a pressure comprised between $10^{-8}$ Torr and the pressure of 1 kBar;
    - in presence of a NH3, N2 or H2 plasma;

- the thermal treatment of atomic monolayers of first and second binary alloys deposited in i) and ii) is made after the step of creation of the initial barrier layer;
- the method further comprises the step of creation of a channel layer by deposit of a binary alloy of GaN, or AlN, or BN, or InN;
- the method further comprises the step of creation of a channel layer by deposit of a ternary alloy of AlGaN, or InGaN, or AlBN, or InBN, or InAlN;
- the method further comprises the step of creation of a channel layer by:

    iv) deposit of an atomic monolayer of a third binary alloy;
    v) deposit of an atomic monolayer of a fourth binary alloy;

    repetition of steps iv) and v) if necessary until the required thickness is obtained;

- the step of creation of a channel layer further comprises thermal treatment of atomic monolayers of third and fourth binary alloys deposited in iv) and v), the thermal treatment being carried out before some deposits of the fourth binary alloy:

    - at a surface temperature between 0°C and 300°C above to the temperature of creation of monolayers of third and fourth binary alloys;
    - under vacuum or ultra-high vacuum between $10^{-8}$ Torr and $10^{-1}$ Torr ;
    - under a gas mixture flow comprising ammoniac NH3 or nitrogen molecule N2 or hydrogen molecule H2 a pressure comprised between $10^{-8}$ Torr and the pressure of 1 kBar;

    in presence of a NH3, N2 or H2 plasma;
- the method further comprises the step of creation of a buffer layer by deposit of a binary alloy of GaN, or AlN, or BN, or InN.

Presentation of the figures

Other characteristics and advantages of the invention will become clear after reading the following description which is given for purely illustrative and non-limitative purposes, and must be read with reference to the attached drawings among which:

- Figure 1 shows a sectional view of a semiconducting material based on a nitride of an III element on which an HEMT type transistor was made;
- figure 2 is a sectional view of a semiconducting material based on a nitride of an III element;
- Figure 3 is a sectional view of an interface between a binary material and a ternary material of the semi-conducting material of the prior art;
- Figure 4 is a sectional view of a ternary material of the prior art;
- Figure 5a is a sectional view of a ternary material illustrating the alloy order in the [001] symmetric planes;
- Figure 5b is a sectional view of a ternary material of the prior are illustrating the alloy order in the [1-101] asymmetric planes;
- Figure 6a is a sectional view of binary and ternary material layers in the case of a ternary material of the prior art;
- Figure 6b is a sectional view of binary and ternary material layers in the case of an ideal ternary material;
- Figure 6c is a sectional view of binary and ternary materials obtained using the method according to the invention;
- Figures 7a to 7g show sectional views of different embodiments according to the invention;
- Figures 8a and 8b show sectional views of examples of pseudo-alloy ternary material obtained by the method according to the invention
- Figure 9 shows an example of semi-conducting material according to the invention,
- Figure 10 shows an example of barrier layer according to the invention
- Figure 11 is a diagram illustrating the thickness of the barrier layer in function of the Al concentration for different embodiments according to the present invention,
- Figures 12A to 12D illustrate the roughness of two embodiments of semi-conducting materials according to the present invention,
- Figures 12E to 12I illustrate different surface morphologies of AlGaN/GaN HEMT structure according to the present invention for different Aluminium concentrations in the AlGaN barrier (25nm thick),
- Figure 13 shows another example of semi-conducting material according to the invention,
- Figures 14 shows two other embodiments according to the present invention.

## Description of the invention

Therefore, one purpose of this invention is to provide a method capable of producing a semiconducting material based on an improved III-N, in other words a material that gives better properties of transistor structures made on it, in terms of charge density and reliability of the final transistor structure.

This is the purpose for which Applicant has studied some material parameters limiting these mobility, charge density and structure reliability properties.

These material parameters are roughness at interfaces, alloy fluctuations and alloy order.

## Type 1 non-homogeneities: roughness at interfaces

The roughness at interfaces may be physical or chemical. The mobility of electrons in the GaN channel layer of a semiconducting material based on III-N is particularly sensitive to the chemical roughness.

The chemical roughness depends on the composition and occurs as soon as a ternary material (for example AlGaN, InGaN, InAlN, AlBN, GaBN) is introduced into the structure.

Figure 3 shows an interface 9 between a GaN channel layer 7 and an $Al_{0.3}Ga_{0.7}N$ barrier layer 8. The GaN channel layer 7 is located below the interface 9, and the $Al_{0.3}Ga_{0.7}N$ barrier layer 8 is located above the interface 9.

It is seen that some atoms 11 of the GaN channel layer 7 located below the interface 9 are above said interface 9: therefore, there is a roughness phenomenon at the $Al_{0.3}Ga_{0.7}N$/GaN interface 9.

## Type 2 non-homogeneities: alloy fluctuations

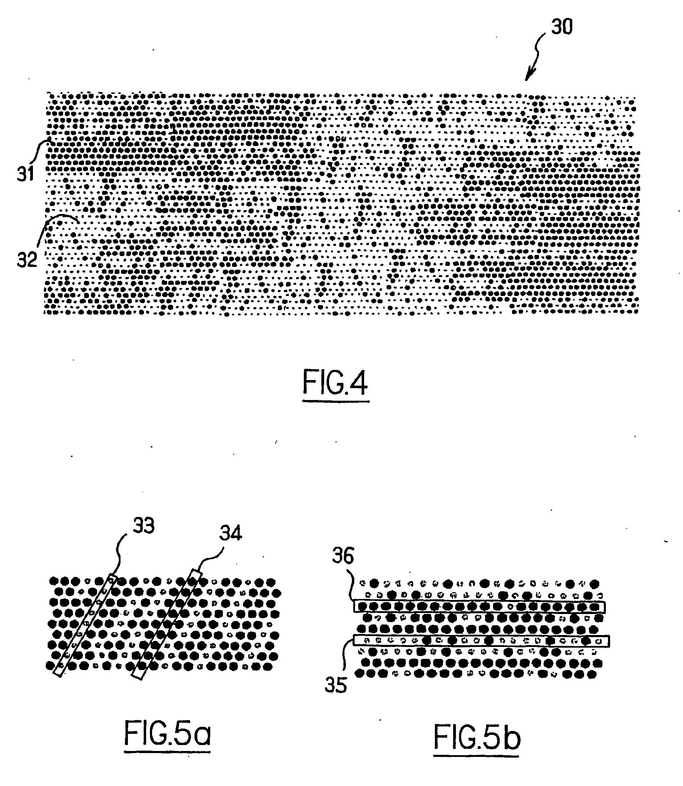

Figure 4 shows a non-homogenous distribution in a barrier layer of AlGaN 30, of a III-N based semiconducting material.

"Gallium rich" areas 31. and "Aluminium rich" areas 32 are frequently created due to surface diffusion rates of Gallium and Aluminium precursors during- the semiconducting material production method, because aggregates form and develop. This type of defect is qualified as an alloy fluctuation.

Alloy fluctuations reduce the mobility of electron and play an important role in the reliability of transistors made from the semiconducting material based on III-N.

In particular, these alloy fluctuations degrade the piezo-electric electron injection that becomes non-homogenous and causes a non-homogenous charge density in the channel of transistors produced on the semiconducting material.

Alloy fluctuations are a main source of failure of power transistors, since the current density in said transistors is not homogenous.

Type 3 non-homogeneities: the alloy order

The alloy order is a defect of the same type as the alloy fluctuation, but at atomic scale.

The alloy order is due to growth parameters and is the result of a partially ordered distribution of the constituent atomic elements of a ternary material.

For example, in the case of an AlGaN barrier layer, "Aluminium rich" atomic planes can be observed alternating with "aluminium depleted" atomic planes.

The average composition of the alloy corresponds to the target, with ordered fluctuations at atomic level.

The alloy order may appear in several crystalline directions. This alloy order may be induced by growth parameters and strain. In all cases, it is a "spontaneous" order that is not deliberately introduced into the semiconducting material. Consequently, it is uncontrolled and non-homogenous.

Figure 5a shows the alloy order in the [1-101] asymmetric planes of an AlGaN barrier layer, in other words in planes perpendicular to the [0001] growth axis. "Aluminium rich" atomic planes 33 and "Aluminium depleted" atomic planes 34 can be seen.

The alloy order is formed in the [1-107] asymmetric planes when epitaxy production systems are used in which the supports are placed on a rotating plate. This is due to the faster depletion of Aluminium and Gallium in the gas or molecular mix used in the method for manufacturing the semiconducting material (uncontrolled parasite reactions of precursors). Thus, the support will be exposed alternately to an "Aluminium rich" gas or molecular mix, then an "Aluminium depleted" gas or molecular mix.

Figure 5b shows the alloy order in the [001] symmetric planes of an AlGaN barrier layer. "Aluminium rich" atomic planes 35 and "Aluminium depleted" atomic planes 36 can be seen.

The alloy order in the [001] symmetry planes is due to non-homogenous strain distributions and differences in the stability of crystalline surfaces.

Effect of type 1, 2 and 3 non-homogeneities

Therefore, the three defect types mentioned above (roughness at interfaces, alloy fluctuations, alloy order) are related to the method used to make the semiconducting material and generate reliability problems for transistor structures made on said semiconducting material.

As already demonstrated using the Ambacher et al. model, the charge density induced by polarisation is very dependent on the Aluminium concentration in the AlGaN barrier layer.

A local variation +/-0.2% of the Aluminium concentration allows making the electronic density fluctuate by $2 \times 10^{12}$ cm$^{-2}$ or more.

As illustrated in Figure 6a, for the case of a classical AlGaN barrier layer 40, the direction and intensity of the piezoelectric field 38 at the interface 39 between the barrier layer 40 and the channel layer 41 will locally depend on the distribution of Ga and Al atoms in the barrier layer 40, which will induce fluctuations in the electronic density at this interface 39.

Similarly, the power output by a transistor structure made on the semiconducting material comprising this standard AlGaN barrier layer will be distributed non-homogenously.

As shown in Figure 6b, the average value of the piezoelectric field 44 for an ideal barrier layer 42, is equal to the local value of this field at any point on the interface 43 between the barrier layer 42 and the channel layer 45. Therefore, the electronic density is homogenous at the interface 43.

Applicant has thus demonstrated the importance of having a semiconducting material that includes a correctly ordered barrier layer in order to limit the three types of non-homogeneities mentioned above, and thus obtain better properties of transistor structures made on the semiconducting material.

In order to obtain a semiconducting material with a correctly ordered barrier layer, Applicant decided to replace the barrier layer made of a ternary alloy within III-N-based semiconducting materials according to prior art, by a barrier layer made of a ternary pseudo-alloy.

For the purposes of this invention, a ternary "pseudo-alloy" is an alloy composed of alternations of atomic monolayers of binary alloys.

It will be understood, in the present invention, that a "monolayer" of binary alloy is composed of one monatomic plane of III element (i.e. Ga, Al, In) and one monatomic plane of nitrogen (N). It will also be understood in the present invention that one "monatomic plane" corresponds to one step of atoms, which also corresponds to a half lattice cell of the crystalline structure.

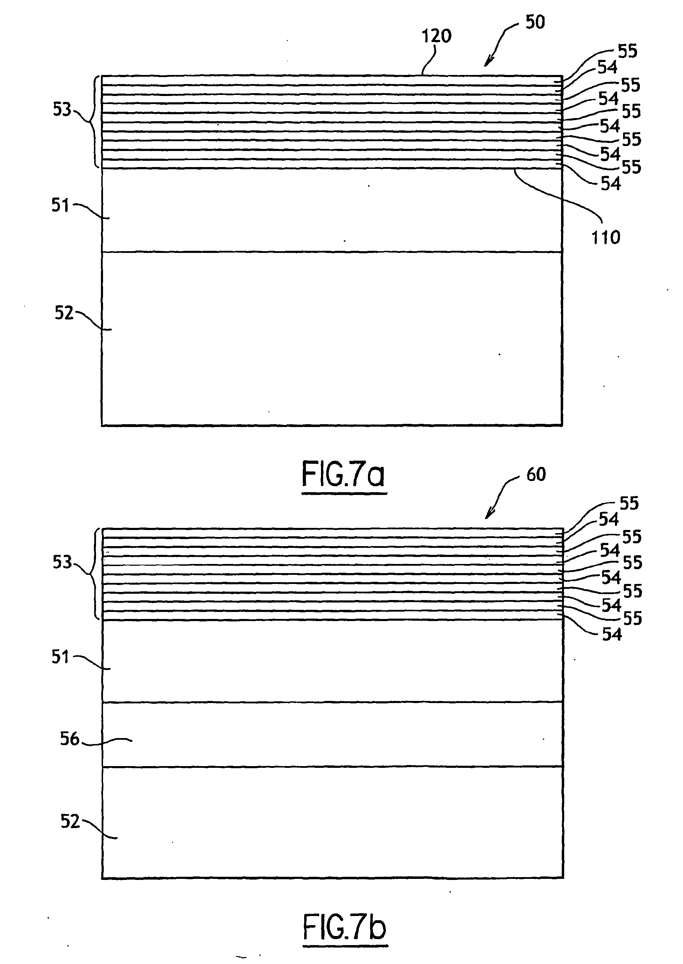

Figure 7a illustrates a semiconducting material 50 according to a first embodiment of the invention.

This semiconducting material 50 comprises a channel layer 51 on a support 52, and a barrier layer 53 made of a ternary pseudo-alloy on the channel layer 51.

The support 52 is made of SiC. However, this support could be made of other materials such as Silicon, AlN, sapphire or GaN.

The channel layer 51 is a binary alloy of GaN. However, another material could have been chosen for the channel layer 51 such as AlN, BN (boron nitride) or InN (Indium nitride) .

This channel layer 51 is deposited on the support by a method known to those skilled in the art such as Molecular Beam Epitaxy (MBE) or Metal-Organic Chemical Vapour Deposition (MOVD) method.

The barrier layer 53 is a ternary pseudo-alloy of AlGaN. This barrier layer 53 comprises binary alloy layers of GaN 54 and binary alloy layers of AlN 55. These GaN and AlN layers are alternated and have constant thickness.

Each layer of first binary alloy made of GaN 54 (or each layer of second binary alloy made of AlN 55) is composed of one or several atomic monolayers of GaN (or AlN).

Those atomic monolayers of GaN and AlN are individually fitted in the semi-conducting material in order to obtain a barrier layer as homogeneous as possible.

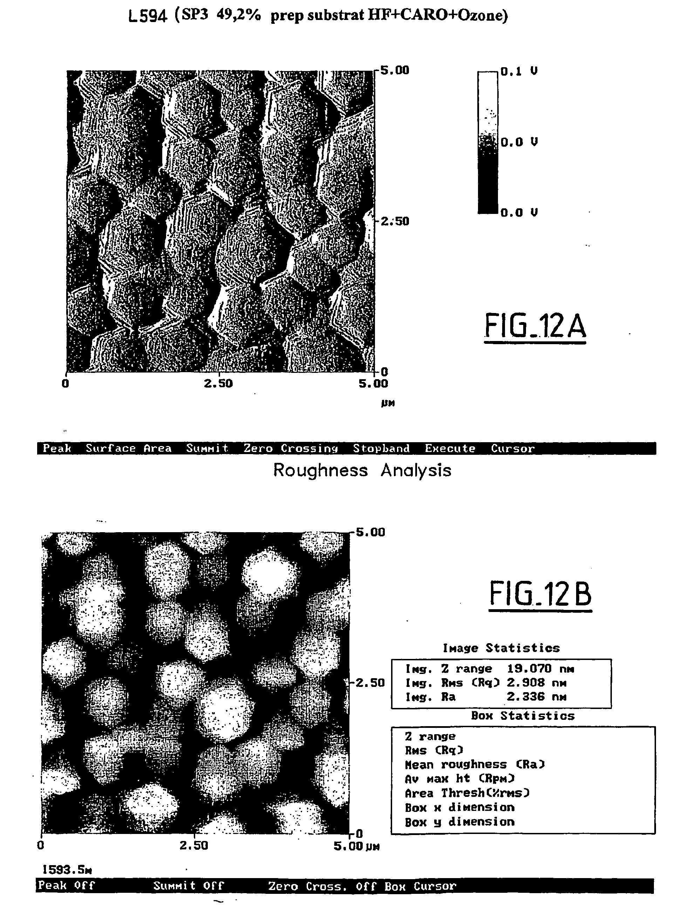

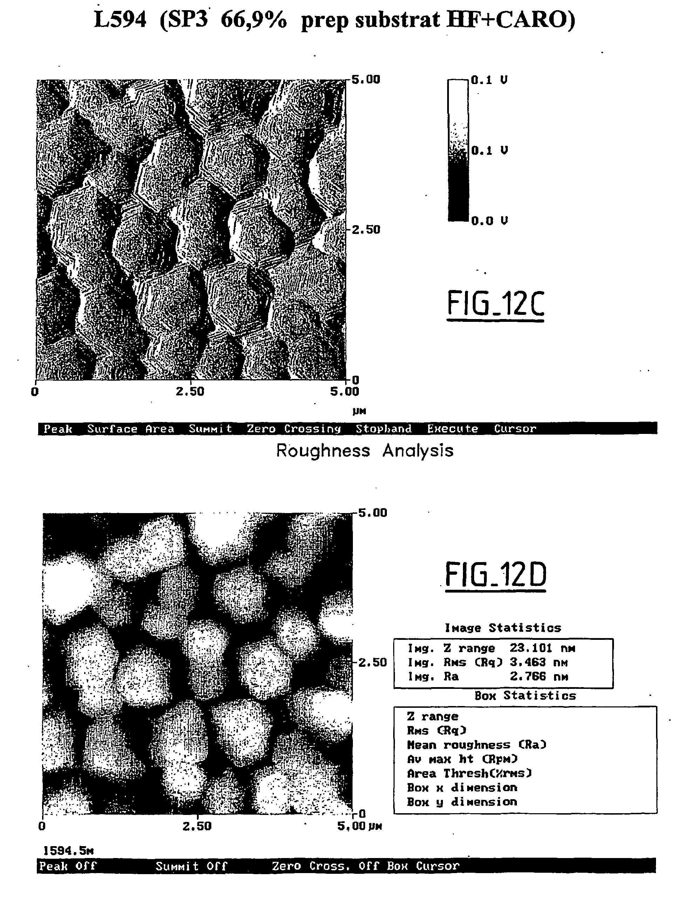

Figure 12A to 12D illustrates the roughness of the semi-conducting materials according to the present invention for different concentrations of Ga and Al in the barrier layer.

The number of atomic monolayers (denoted $n_{GaN}$) per layer of the first binary alloy made of GaN 54 can vary between 1 and 40, and preferably between 1 and 20, and even more preferably between 2 and 10. Similarly, the number of atomic monolayers (denoted $n_{AlN}$) per layer of the second binary alloy made of AlN 55 can vary between 1 and 40, and preferably between 1 and 20, and even more preferably between 2 and 10.

It shall be appreciated that existing processes such as the one disclose by Ups6100542 indeed involve making layers with an alternation of very thin elementary layers - and in this respect these processes present some similarities with the alternation of monolayers mentioned above. However, US6100542 addresses materials based on arsenides and not nitrides, and its alternation aims at maximizing the doping of the larger layer thus constituted with the elementary layers. US6100542 does not address the issue of homogeneity of the distribution of electrons. Indeed, US6100542 concerns non piezoelectric structure. Man skilled in the art knows that alloy disorders in the layers of a non piezoelectric arsenide structure do not interfere with the homogeneity of the distribution of electrons. Hence, materials based on arsenide which comprise an alternation or elementary layers do not address the issue of homogeneity of the distribution of electrons.

It shall also be appreciated that existing processes such as the one disclosed in WO02/093650 indeed involve making layers with an alternation of "monolayers" as mentioned at page 7 third paragraph of WO02/093650.

However, the "monolayers" described in WO02/093650 are far from the definition of nonolayer in the sense of the present invention. Indeed, the "monolayers" as described in WO02/093650 are in the range of 5 to 20 angstrom thick (see WO02/093650 page 7 third paragraph), which is very thick with respect to the monolayers of the present invention which are atomic monolayers.

WO02/093650 addresses the problem of increasing the electron mobility within the structure.

However, WO02/093650 does not address the issue of increasing the homogeneity of the electron distribution (particularly in the channel layer). Indeed WO02/093650 does not suggest monolayers as defined in the present invention (the "monolayer" as defined in WO02/093650 being very thicker as the one of the present invention).

Coming back to the invention, the production method known to those skilled in the art such as liquid phase epitaxy, or vapour phase epitaxy or molecular beam epitaxy is used to grow the barrier layer 53 on the channel layer of GaN.

The barrier layer 53 is created starting by depositing a layer of the first binary alloy of GaN 54 in which the number of atomic monolayers $n_{GaN}$ is between 1 and 40, preferably between 1 and 20 and even more preferably between 2 and 10, and the next step is to deposit a layer of the second binary alloy of AlN in which the number of atomic monolayers $n_{AlN}$ is between 1 and 40, preferably between 1 and 20 and even more preferably between 2 and 10.

The next step is to deposit layers of the first binary alloy of GaN and layers of the second binary alloy of AlN until the required thickness of the barrier layer 53 is obtained, varying between 2 and 500 nm.

In the embodiment shown in Figure 7a, the numbers of atomic monolayers $n_{GaN}$ and $n_{AlN}$ are equal. However, the numbers of atomic monolayers $n_{GaN}$ and $n_{AlN}$ could be different.

Since the barrier layer 53 is composed of alternations of layers of GaN and AlN, the gas or molecular precursors of Gallium and of Aluminium (or Gallium and Aluminium) are not mixed during the production method and there is no mix depletion phenomenon.

Thus, alloy fluctuations are limited:

- at the nanometric and micrometric scales (type 1 non-homogeneities), and

- at the atomic scale (type 2 and 3 non-homogeneities).

Therefore the structure of the barrier layer 53 is perfectly ordered along the [0001] growth axis.

As illustrated in Figure 6c, this has the effect of:

- limiting the chemical roughness and consequently limiting the diffusion of electrons at the interface 90 between the channel layer 91 and the barrier layer 92 (this barrier layer being composed of an alternation of AlN layers 93 and GaN layers 94),
- optimising the distribution of the piezoelectric field for which the average value is equal to the local value of the piezoelectric field 95 at all points on the interface 90.

Therefore, the injection of electrons by this field is optimised. Moreover, the distribution of electrons injected into the two-dimensional gas (2 DEG) is homogenous since the induced piezoelectric field is homogenous.

Consequently, this structure provides a means of optimising the mobility and the surface density of electrons located in the two-dimensional gas (2 DEG) .

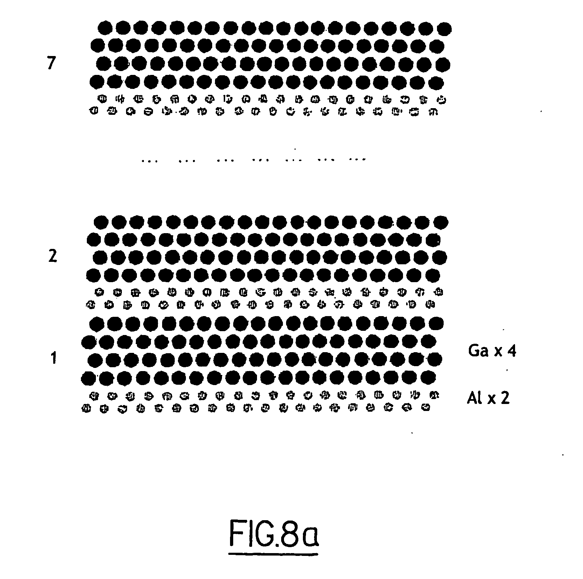

Figure 8a illustrates an example embodiment of a barrier layer according to this invention. In this example, a 20.5 nm thick barrier layer of AlGaN containing 32.2% of aluminium was replaced by a barrier layer made of a ternary pseudo-alloy:

$$(\text{AlN } n_{AlN} = 2 \ / \ \text{GaN } n_{GaN} = 4)_{X=7}$$

where:

- $n_{AlN}$ is the number of atomic monolayers of AlN,
- the thickness of an AlN monolayer is $e_{AlN} = 0.2485$ nm,
- $n_{GaN}$ is the number of atomic monolayers of GaN,
- the thickness of an GaN monolayer is $e_{GaN} = 0.2590$ nm,
- X is the number of periods (AlN $n_{AlN} = 2$ / GaN $n_{GaN} = 4$),
- Y is the average composition of the barrier:

$$Y = n_{AlN} \ / \ (n_{GaN} + n_{AlN}) = 32.2\%,$$

- E is the equivalent thickness of the barrier:

$$E = X \times (n_{AlN} \times e_{AlN} + n_{GaN} \times e_{GaN}) = 20.1 \text{ nm}.$$

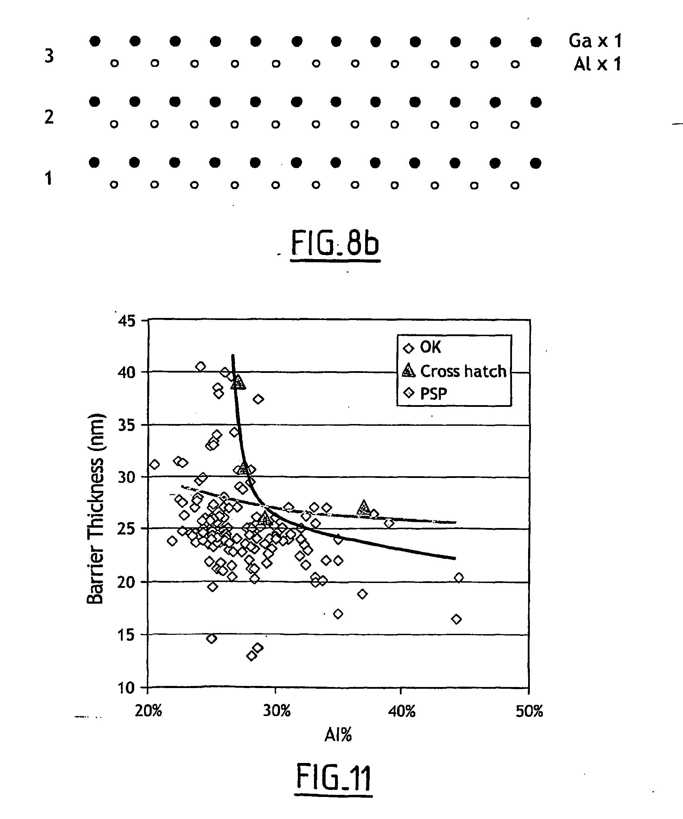

Figure 8b illustrates another example embodiment of a barrier layer according to this invention. In this example, a barrier layer of AlGaN containing 50.0% of aluminium was replaced by a barrier layer made of a ternary pseudo-alloy:

$$(\text{AlN } n_{AlN} = 1 \ / \ \text{GaN } n_{GaN} = 1)_{X=3}$$

Figure 7b illustrates a semiconducting material 60 made according to a second embodiment of this invention.

In this second embodiment, a buffer layer 56 has been inserted between the channel layer 51 and the support 52.

The buffer layer 56 is a material chosen from among GaN and AlGaN. This buffer layer facilitates growth of the GaN channel l.ayer. This buffer layer is deposited by bonding or by another known method to those skilled in the art such as an epitaxy method.

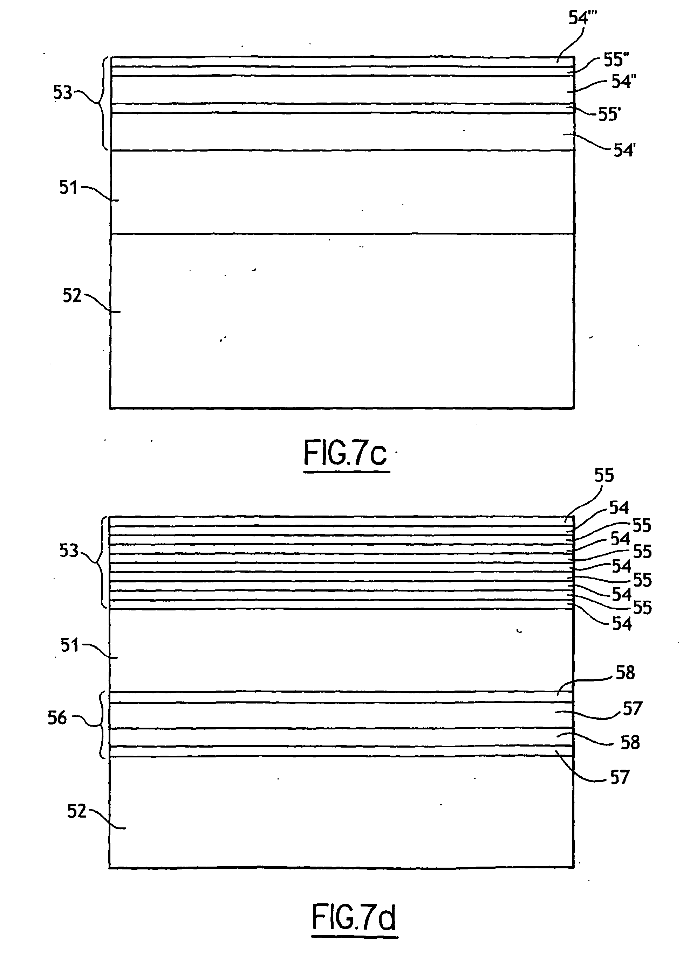

In the embodiment illustrated in figure 7c, the barrier layer 53 comprises GaN layers 54', 54'', 54''' without the same number of atomic monolayers $n_{GaN}$.

Layers 54', 54'', 54''' comprise eight, five and two atomic monolayers of GaN, respectively. These layers alternate with AlN layers 55' and 55'', the layer 55' being furthest from the support, and the layer 54''' being closest to the support.

In the illustration in Figure 7c, the number of atomic monolayers $n_{GaN}$ per layer of GaN 54', 54'', 54''' decreases as the distance from the support 52 increases. However, it would be possible to have a barrier layer 53 in which the number of atomic monolayers increases as the distance from the support 52 increases.

Thus, the number of atomic monolayers $n_{GaN}$ per GaN layer can vary along the barrier layer 53.

The same is true for the number of monolayers $n_{AlN}$ per AlN layer that can also vary along the barrier layer 53.

In the barrier layer, the number of monolayers of GaN and AlN can vary independently as shown in figure 7c where the number of atomic monolayers nGaN per layer of GaN 59', 54'', 54''' vary whereas the number of atomic monolayers nAlN per layer of AlN 55' and 55'' do not vary.

The numbers of monolayers $n_{GaN}$ and $n_{AlN}$ can also vary simultaneously along the barrier layer. For example, the number of atomic monolayers $n_{AlN}$ can vary so that it decreases (or increases) as the distance from the support increases, and the number of atomic monolayers $n_{GaN}$ can vary so that it increases (or decreases) as the distance from the support increases.

Consequently, the number of atomic monolayers of each layer of binary alloy may vary between a first value on a back face of the barrier layer and a second value on a front face of the barrier layer, the back face being closer to the support than the front face.

Figure 7d illustrates a semiconducting material according to a fourth embodiment. This semiconducting material includes a support 52, a buffer layer 56, a channel layer 51 and a barrier layer 53.

In this embodiment, the buffer layer 56 is a ternary pseudo-alloy of AlGaN composed of alternating layers of binary alloy of GaN 57 and binary alloy of AlN 58.

The buffer layer 56 has the same characteristics as the ternary pseudo-alloy barrier layer and $n_{AlN}$ between 1 and 40, preferably between 1 and 20, and even more preferably between 2 and 10 and possibly varying along the buffer layer, etc.).

In this embodiment, the buffer layer 56 comprises two GaN layers 57 alternating with two AlN layers 58.

Furthermore, the number of atomic monolayers $n_{GaN}$ per GaN layer 57 varies along the buffer layer 56. The GaN layer 57 closest to the support comprises two atomic monolayers while the GaN layer furthest from the support comprises four atomic monolayers.

The number of atomic monolayers $n_{AlN}$ per AlN layer 58 can also vary along the buffer layer 56. The GaN layer 57 closest to the support comprises 6 atomic monolayers while the AlN layer furthest from the support comprises three atomic monolayers.

Thus, in the embodiment illustrated in Figure 7d, the numbers of atomic monolayers per layer of GaN and AlN vary along the buffer layer, the number of atomic monolayers $n_{AlN}$ varying so that it decreases as the distance from the support increases, and .the number of atomic monolayers $n_{GaN}$ varies so that it increases as the distance from the support increases.

The reader will have understood that the numbers of atomic monolayers $n_{AlN}$ and $n_{GaN}$ may be fixed along the buffer layer as was the case for the barrier layer illustrated in Figure 7a.

This buffer layer can be obtained by a production method known to those skilled in the art such as an epitaxy method (molecular beam epitaxy, liquid phase epitaxy, vapour phase epitaxy).

In summary, the barrier layer (53) made of an AlGaN ternary pseudo alloy may be denoted:

$$(AlNn_{alN}/GaNn_{GaN}) \times$$

where:

- $n_{AlN}$ is a number of atomic monolayers of an AlN layer where $1 \leq n_{AlN} \leq 40$, preferably $1 \leq n_{AlN}$ 20, more preferably $2 \leq n_{AlN} \leq 10$) and where $n_{AlN}$ can vary along the barrier layer.
- $n_{GaN}$ is a number of atomic monolayers of a GaN layer where $1 \leq n_{GaN} \leq 40$, preferably $1 \leq n_{GaN} \leq 20$, more preferably $2 \leq n_{GaN} \leq 10$) and where $n_{GaN}$ can vary along the barrier layer.
- X is the number of layers of GaN and AlN.

In order to further improve the electronic properties of the semiconducting materials based on III-N, the barrier layer may include one or several layers of ternary alloy in addition to the alternation of layers of binary alloys at the atomic scale.

Applicant has pointed out that the presence of a layer of ternary alloy in the barrier layer comprising the alternation of layers of binary alloys was able to improve the homogeneity of the piezoelectric field and to increase the mobility of charge carriers of the semi-conducting materials.

The creation of barrier layer 53 may include the same steps as described above.

It is thus possible to start by creating an initial barrier layer by deposit of a layer of a first binary alloy of GaN 54, deposit of a layer of a second binary alloy of AlN 55, and repetition of these deposits steps of layers of GaN and AlN until the required thickness is obtained for the barrier layer 53.

Furthermore, a step of creation of one or several layers of ternary alloy in or on the initial barrier layer is made.

The step of creation of layer(s) of ternary alloy varies according to the embodiment of the semi-conducting substrate.

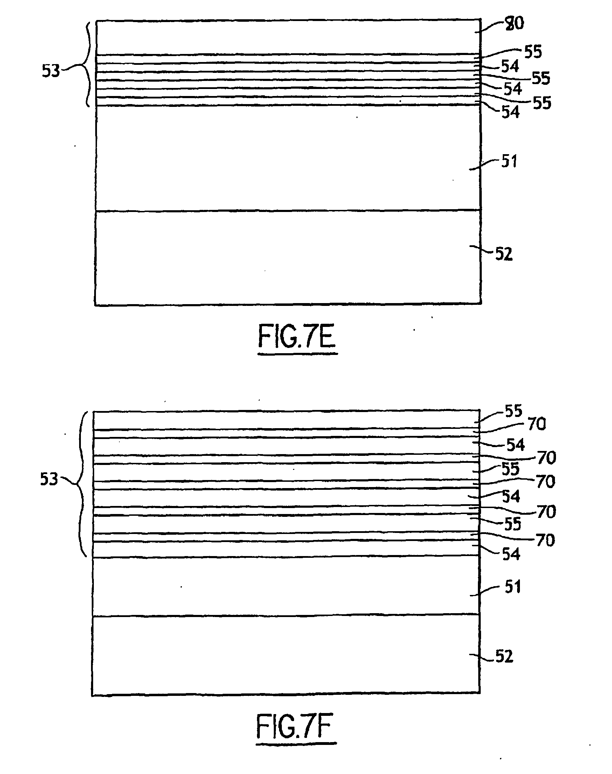

In one embodiment illustrated in figure 7e, the barrier layer 53 comprises a layer of ternary alloy 80 of AlGaN and an alternation (at the atomic scale) of layers of a first binary alloy 54 of GaN and of a second binary alloy 55 of AlN.

It will be understood that the atomic scale is the scale of the angstrom.

Each layer of binary alloy of GaN (or AlN) of the alternation comprises between 1 and 40 atomic monolayers of GaN (or AlN), preferably between 1 and 20, and even more preferably between 2 and 10. In all cases, each layer of binary alloy of GaN (or AlN) of the alternation comprises at least one atomic monolayer of this binary alloy of GaN (or AlN).

The alternation of layers of binary alloys 54, 55 of GaN and AlN is located between the layer of the ternary alloy 80 of AlGaN and the support 52. In other words, the layer of the ternary alloy 80 of AlGaN is on top of the alternation of layers of binary alloys of GaN and AlN.

The presence of the layer of ternary alloy 80 on top of the alternation of layers of binary alloys 54, 55 of GaN and AlN allows immediate compatibility with the technical methods optimized for semi-conducting materials comprising a barrier layer made of a layer of ternary alloy of AlGaN, especially regarding the making of ohmic contacts, while keeping the benefit of the optimal electronic injection obtained thanks to the alternation at the atomic scale of binary alloys 54, 55 of GaN and AlN in the barrier layer 53.

Indeed, the applicant has pointed out that the importance of having an ordered alloy in the barrier layer 53 decreases as the distance from the interface between the barrier layer and the channel layer 51 increases. In other words, a semi-conducting material having, an alloy disorder in a layer located far from the interface between the channel layer 51 and the barrier layer 53 has a better mobility of the charge carriers and a piezoelectric polarization field more homogeneous than a semi-conducting material having an alloy disorder in a layer located closed to the interface between the channel layer 51 and the barrier layer 53

The step of creation of the layer of ternary alloy 80 of AlGaN, allowing the semi-conducting material shown in figure 7e to be obtained, comprises the deposit of a classical layer of ternary alloy created by epitaxy.

It will be understood, in the present invention, that a "classical layer of ternary alloy" is a layer of ternary alloy created by epitaxy by making interact in a low residual pressure room (ultra-high vacuum, residual pressure comprised between $10^{-9}$ Torr and $10^{-14}$ Torr) atomic or molecular flows (obtained by evaporation of solid sources or by direct injection of gas precursors of GaN and AlN) on the substrate heated to an appropriate temperature for the epitaxial growth.

In another embodiment shown in figure 7f, the barrier layer 53 comprises a plurality of layers of ternary alloy 70 of AlGaN. Those layers of ternary alloy 70 of AlGaN are located in the alternation of layers of binary alloys 54, 55 of GaN and AlN.

The layers of ternary alloy 70 of AlGaN interbedded in the alternation of layers of binary alloys 54, 55 of GaN and AlN are obtained by interdiffusion of the III elements of the layers of binary alloys 54, 55 of GaN and AlN.

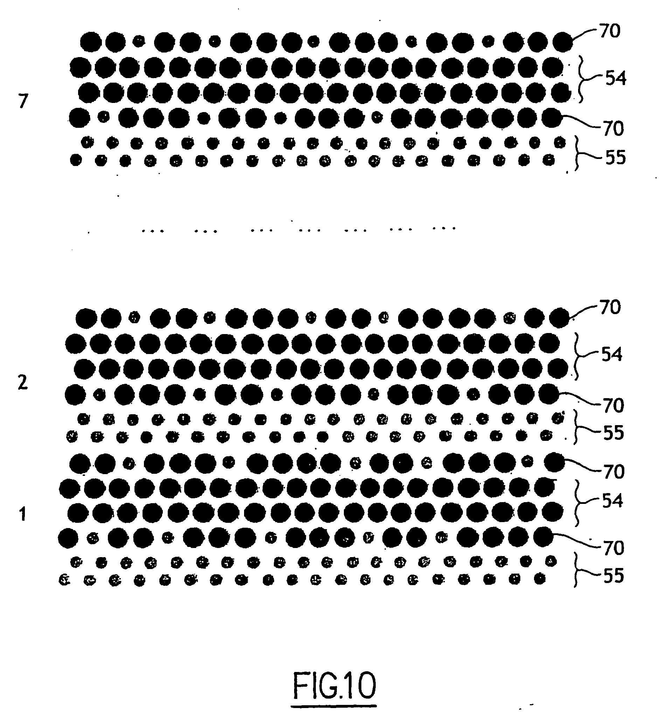

Figure 10 is a sectional view, at the atomic scale, of the barrier layer from the embodiment illustrated in figure 7f. Each layer of binary alloy of GaN (or AlN) comprises two atomic monolayers. Each layer of ternary alloy of AlGaN comprises one atomic monolayer of ternary alloy.

The presence of layers of ternary alloy 70 between the layers of binary alloys 54, 55 allows avoiding the violent variations of composition in the barrier layer 53. This improves the homogeneity of the local piezoelectric polarisation field. This homogenisation of the polarisation field allows decreasing the charge density fluctuations at the interface between the channel layer 51 and the barrier layer 53.

The creation of the plurality of layers of ternary alloy 70 illustrated in figure 7f comprises a thermal treatment after having created at least one alternation of layers of binary alloys 54, 55 of GaN and AlN deposited for the creation of the barrier layer 53.

The thermal treatment can be realised at the end of the step of creation of the barrier layer 53 (that is to say after the successive deposit steps of the layers of the first binary alloy 54 of GaN and the second binary alloy of AlN).

This treatment can also be realized during the steps of creating the barrier layer. In that case, the thermal treatment is carried out before some deposit steps of the second binary alloy.

For example, one can begin to deposit the first binary alloy (GaN). Then, one can deposit the second binary alloy (AlN). Then, on can carry out the thermal treatment which allows better inter-diffusion of the III elements of the layers of binary alloys 54, 55 of GaN and AlN. The diffusion, very local, can take place on a typical distance of 1 to 5 material monolayers.

The thermal treatment is carried out after at least some binary alloy deposits. Typical conditions for this treatment are:

- at a surface temperature between 0°C and 300°C above to the temperature of creation of monolayers of first and second binary alloys;
- under vacuum or ultra-high vacuum between $10^{-8}$ Torr and $10^{-1}$ Torr ;
- under a gas mixture flow comprising ammoniac NH3 or nitrogen molecule N2 or hydrogen molecule H2 a pressure

comprised between $10^{-8}$ Torr and the pressure of 1. kBar;

- in presence of a NH3, N2 or H2 plasma.

A layer of ternary alloy 70 of AlGaN is then obtained, located between the layers of the first and second binary alloys of GaN and AlN. This layer of ternary alloy comprises between 1 and 5 monolayers of ternary alloy.

If the barrier layer thickness does not correspond to the required thickness, a deposit of a layer of GaN is made and a deposit of a layer of AlN is made. Then, the thermal treatment is carried out, and so on until the thickness corresponds to the required thickness.

The reader will appreciate that it can be chosen not to carry out the thermal treatment systematically after each deposit of a layer of the second binary alloy.

For example, the thermal treatment can be made once on two times. That is to say the thermal treatment is carried out after two deposits of a layer of a binary alloy have been made.

The thermal treatment may also be carried out only once at the end of the creation step of the initial barrier layer, that is to say once the required barrier layer thickness is obtained.

Moreover, before carrying out the thermal treatment, it is possible to deposit an additional layer of AlN or SiN in order to stabilize the surface of the barrier layer 53 during the thermal treatment.

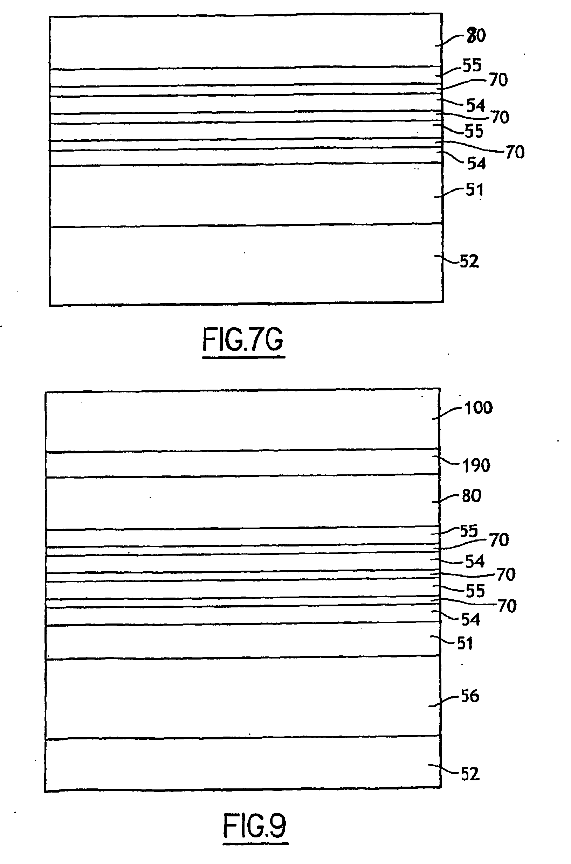

In figure 7g, a semi-conducting material according to another embodiment of the present invention is shown. In this embodiment, the semi-conducting material comprises the same elements as the embodiment illustrated in figure 7. Those same elements are the alternation of layer of binary alloys 54, 55 of GaN and AlN, and the plurality of layers of the ternary alloy 70 located in the alternation.

Moreover, the embodiment illustrated in figure 7g comprises a classical layer of ternary alloy on top of the alternation. This allows gathering the advantages of the embodiments illustrated in figures 7e and 7f.

The man skilled in the art will appreciate that it is possible to realize a semi-conducting material comprising a channel layer or a buffer layer comprising the same elements (layers alternation of binary alloys, etc.) than those described for the barrier layer. Having a channel layer or a buffer layer made of ternary pseudo-alloy allows increasing the homogeneity of the distribution of the electrons in the semi-conducting material.

Figure 9 shows an example of semi-conducting material realization according to the present invention. In this example, the semi-conductor comprises:

- a Si (silicon) substrate 52,
- a buffer layer 56 made of a $Al_{0.1}Ga_{0.9}N$ alloy,
- a channel layer 51 made of a $In_{0.25}Ga_{0.75}N$ ternary pseudo-alloy of a thickness of 155 Angstroms,
- an alternation of layer of binary alloys 54, 55 made of ternary pseudo-alloy $Al_{0.32}Ga_{0.68}N$ of a thickness of 184 Angstroms,
- a layer of a classical ternary alloy 80 of $Al_{0.4}Ga_{0.6}N$ of a thickness of 50 Angstroms,
- a layer of binary alloy 190 of GaN of a thickness of 20 Angstroms,
- a layer of binary alloy 100 of AlN of a thickness of 30 Angstroms.

In the different embodiments illustrated in figures 7a to 7g, the channel layer is made of binary alloy of GaN. In other embodiments, the channel layer is a ternary pseudo-alloy of AlGaN, or InGaN, or AlBN, or InBN, or InAlN.

In these other embodiments, the channel layer is created using a similar method to the one described for the creation of the barrier layer, and the binary alloys for making the ternary pseudo-alloy are chosen from among AlN, GaN, BN, and InN.

When the channel layer is made of a ternary pseudo-alloy, it comprises the same features as the ternary pseudo-alloy barrier layer (number of atomic monolayers per layer of binary alloy comprised between 1 and 40, preferably between 1 and 20, and more preferably between 2 and 10, this number being able to vary along the thickness of the channel layer). By having a channel layer made of ternary pseudo-alloy, the homogeneity of the semi-conducting material (and particularly the distribution of electrons) is increased.

The surface morphology of AlGaN/GaN HEMT structure is generally affected by Al concentration in the barrier.

The semi-conducting material according to the invention allows increasing the aluminium concentration in the barrier layer (or channel layer, or buffer layer) as illustrated in figure 11.

Indeed, by decreasing the roughness at the interface between the channel layer and the barrier layer, it is possible to increase the concentration of Al in the layer.

In fact, the perturbations (homogeneity of the electronic density ...) in a layer are principally due to the Al atoms. Hence, for a given roughness, it is possible with the present invention to increase the concentration of aluminium.

OK data points of figure 11 correspond to structures according to the present invention which are grown on Si 111 substrates for different thicknesses and Aluminium concentrations measured by XRD.

As shown in figure 11, thick barrier layers are achievable (up to 41nm for 23% Aluminium), but most results correspond to thin barrier layers.

Typical thicknesses ranging between 20nm and 27nm have shown best results after device fabrications.

Below 25 nm, Aluminium concentration in the 28%-30% range is a standard specification leading to optimised ohmic contacts.

For higher Al concentrations (32% and more), barrier thickness must be decreased down to 15-20nm.

Cross Hatch data points of figure 11 correspond to cross-hatched structures according to the present invention for different thicknesses and Aluminium concentrations measured by XRD.

In this case, relaxation of the AlGaN barrier occurs, leading to micro-cracks on the surface.

This strain effect appears when Aluminium concentration is to high in regards with barrier thickness.

The trend is given by curve 500. Applicant recommends specifying barrier layers thickness/Al% below this curve 500.

PSP data points correspond to pseudomorphic structures according to the present invention with strained GAN channel on $A_{10.1}Ga_{0.9}N$ buffer layer.

As shown in figure 11, it is possible, with such pseudomorphic structures, to reach concentrations of 40% in Aluminium even for thick barriers (26nm).

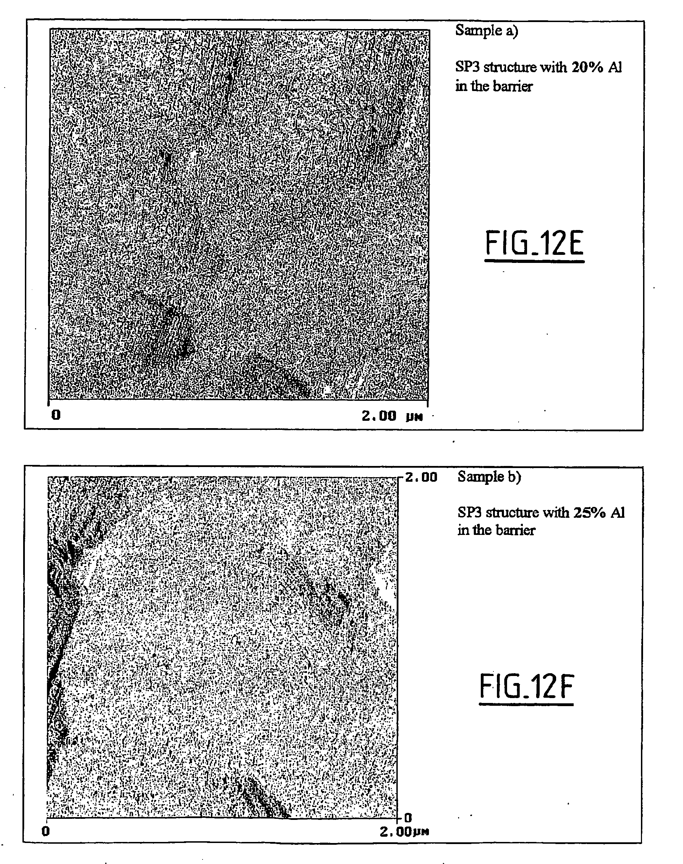

Figures 12E to 12I illustrate the surface morphology of different structures according to the present invention with various Aluminium concentrations in the AlGaN barrier.

Figure 12E shows a structure according to the present invention having an Aluminium concentration of 20% in the AlGaN barrier of a thickness equal to 25nm.

Figure 12F shows a structure according to the present invention having an Aluminium concentration of 25% in the AlGaN barrier of a thickness equal to 25nm.

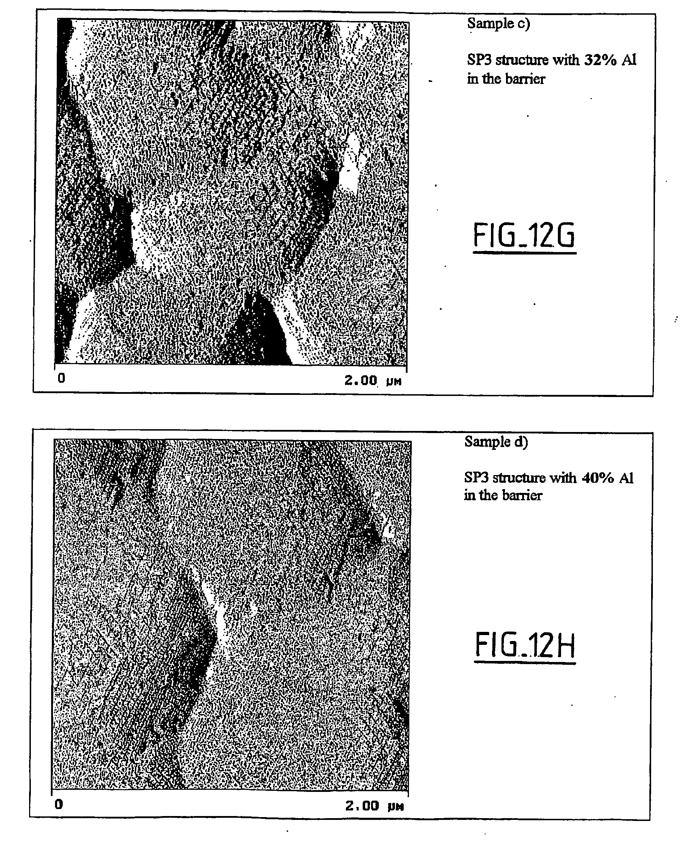

Figure 12G shows a structure according to the present invention having an Aluminium concentration of 32% in the AlGaN barrier of a thickness equal to 25nm.

Figure 12H shows a structure according to the present invention having an Aluminium concentration of 40% in the AlGaN barrier of a thickness equal to 25nm.

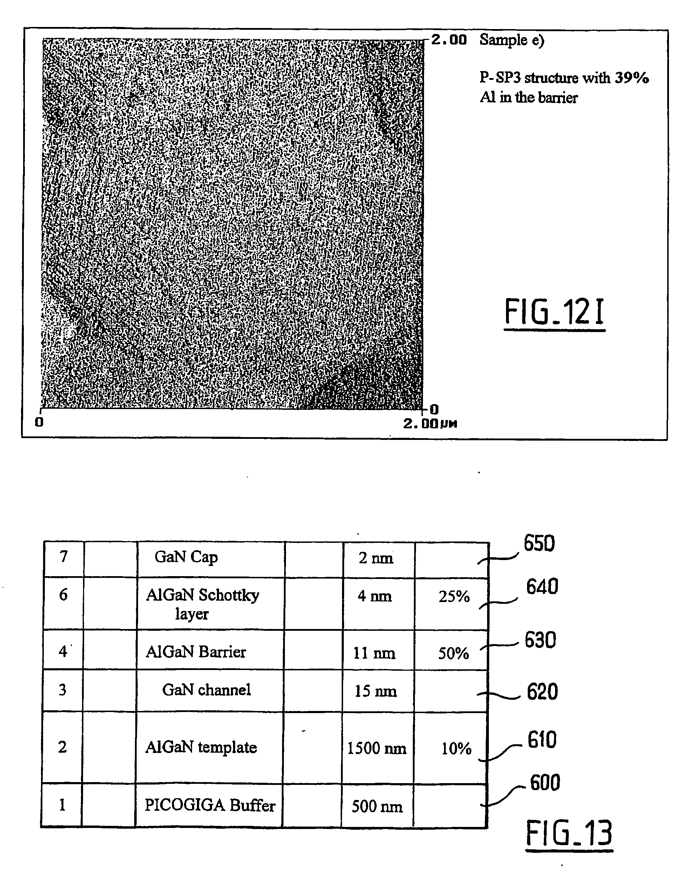

Figure 12I shows a structure according to the present invention having an Aluminium concentrations of 39% in the AlGaN barrier of a thickness equal to 26nm.

As is shown on figures 12E to 12I, no differences are observed on the surface morphology for every layers.

In the different embodiments illustrated in figures 7a to 7g, the barrier layer is a ternary pseudo-alloy of AlGaN. In other embodiments, the barrier layer is a ternary pseudo-alloy of InGaN (indium gallium nitride), or AlBN (aluminium boron nitride), or InBN (indium boron nitride, or InAlN (indium aluminium nitride). In these other embodiments, the first and second binary alloys making the ternary pseudo-alloy are chosen from among AlN, GaN, BN, and InN.

Figure 13 shows another embodiment according to the present invention.

This other embodiment comprises:

- a substrate 600 having a thickness of 500 nm,
- an AlGaN template layer 610 having a thickness of 1500 nm which comprises 10% of Aluminium in concentration,
- a GaN channel layer 620 having a thickness of 15 nm,
- a barrier layer 630 having a thickness of 11 nm which comprises 50% of Aluminium in concentration,
- an AlGaN Schottky layer 640 having a thickness of 4 nm which comprises 25% of Aluminium in concentration, and
- a GaN cap layer 650 having a thickness of 2 nm.

The barrier layer of the semi-conducting material illustrated in figure 13 comprises alternations of one monolayer of AlN (one monatomic plane of Al and one monatomic plane of N) and one monolayer of GaN (one monatomic plane of Ga and one monatomic plane of N).

The present invention presents some advantages thank to the use of monolayers, which allows obtaining ordered ternary pseudo-alloy, as AlGaN layer having a concentration of 50% of Aluminium (Al - N - Ga - N).

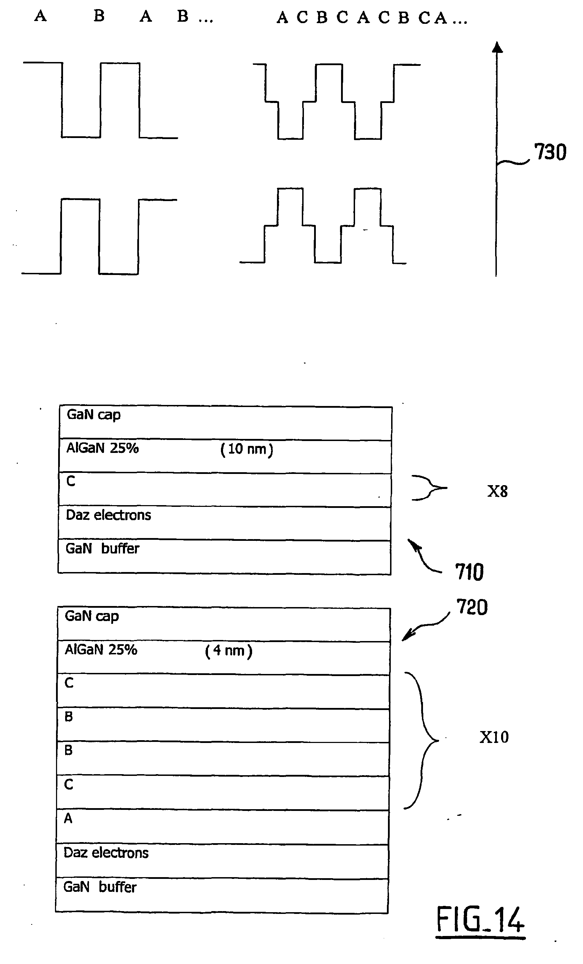

Figure 14 shows some advantages of the present invention compared to the process and device described in WO02/093650.

In figure 14:

- A represents an AlN lattice cell (Al - N - Al - N),
- B represents a GaN lattice cell (Ga - N - Ga - N),
- C represents an AlGaN lattice cell (Al - N - Ga - N).

As can be observed with the alternation C - A - C - B... according to the present invention and illustrated on the top of figure 14, the present invention allows smoothing of the forbidden band diagram 730:

- the energy diagram is smoothed (Eg is the energie of the forbidden band of the alloys: Eg(GaN)=3.4eV, Eg(AlN) = 6.2 eV, Eg(AlGaN 50%) = 4.8eV,

- the strain, in the structure presents a better distribution which allows to obtain more reliable transistor structures.

On the contrary, the process and device described in WO02/09365 does not allow smoothing of the forbidden band diagram 730.

Indeed, the process described in WO02/093650 does not allow obtaining an AlGaN lattice cell C (Al - N - Ga - N) (since the "mono-Layers" as defined in WO02/093650 are thick). Hence, the process described in WO02/093650 only allows obtaining alternations A - B - A - B... as illustrated on top of figure 14.

Embodiment 710 and 720 are two examples of semi-conducting material according to the present invention which comprise C layers.

Although some examples of embodiments of the present invention were described in detail above, those skilled in the art will easily understand that many modifications could be made without physically going outside the scope of the new information and the advantages described herein. Consequently, all modifications of this type will be included in the scope of this invention as defined in the attached claims.

References

[1] The blue laser diode, S. Nakamura, Springer 1999;

[6] K. Asano, Y. Miyoshi, K. Ishikura, Y. Nashimoto, M. Kuzuhara, M. Mizuta, IEDM -1998) 59.

[7] R.A. Sadler, S.T. Allen, T.S. Alcorn, W.L. Pribble, J. Surnakeris, J.W. Palmour, 56th Device Research Council (1998) 92.

[9] S.T. Sheppard, K. Doverspike, W.L. Pribble, S.T. Allen, J.W. Palmour, L.T. Kehias, T.J. Jenkins, IEEE Elec. Dev. Lett. 20 (1999) 161

[18] H.M. Ng., D. Doppalapudi, T.D. Moustakas, N.G. Weimann, L.F. Eastman, Appl. Phys. Lett. 73 (1998) 821.

[19] S. Keller, G. Parish; P.T. Fini, S. Heikman, C.H. Chen, N. Zhang, S.P. DenBaars, U.K. Mishra, J. Appl. Phys. 86 (1999) 5850.

[20] I.P. Smorchkova, C.R. Elsass, J.P. Ibbetson, R. Vetury, B. Heying, P. Fini, E. Haus, S.P. DenBaars, J.S. Speck, U.K. Mishra, J. Appl. Phys. 86 (1999) 4520.

[21] H. Morkoc, Modulation doped AlGaAs/GaAs heterostructures in "The Technology and physics of molecular beam epitaxy, ed E.H.C. Perker, Plenium press 1985.

[22] O. Ambacher, J. Smart, J.R. Shealy, N.G. Weinmann, K. Chu, M. Murphy, W.J. Schaff, L.F. Eastman, R. Dimitrov, L. Wittmer, M. Stutzmann, W. Rieger, J. Hilsenbeck, J. Appl. Phys. 85 (1999) 3222.

[23] F. Bernardini, V. Fiorentini, D. Vanderbilt, Phys. Rev. B 56 (1997) R10024.

**Claims**

1. Semi-conducting substrate (60) based on elements in column III in the periodic table and nitrogen, to be used for example for manufacturing of HEMT type transistor structures, comprising a support (52), a channel layer (51) on the support and a barrier layer (53) on the channel layer, wherein the barrier layer (53) is composed of an alternation of layers composed of at least one atomic monolayer of first and second III-N binary semi-conducting alloys (54, 55), each atomic monolayer being composed of one monoatomic plane of III elements and one monoatomic plane of nitrogen.

2. Semi-conducting substrate according to claim 1, wherein the channel layer comprises an alternation of layers composed of at least one atomic monolayer of third and fourth III-N binary semi-conducting alloys.

3. Semi-conducting substrate according to claim 1 or 2, wherein the semi-conducting substrate (60) further includes a buffer layer (56) between the support (52) and the channel layer (51), the buffer layer (56) comprising an alternation of layers composed of at least one atomic monolayer of fifth and sixth III-N binary semi-conducting alloys.

4. Semi-conducting substrate according to claim 1, 2 or 3, wherein the number of atomic monolayers in each binary alloy of the alternation of the barrier layer or of the channel layer or of the buffer layer Is comprised between 1 and 20.

5. Semi-conducting substrate according to claim 1 or 2 or 3, wherein the number of atomic monolayers in each binary alloy of the alternation of the barrier layer or of the channel layer or of the buffer layer varies between a first value on a back face of the barrier layer or of the channel layer or of the buffer layer, and a second value on a front face of the barrier layer or of the channel layer or of the buffer layer, the back face being closer to the support (52) than the front face.

6. Semi-conducting substrate according to claim 5. wherein the first and second values are comprised between 1 and 20.

7. Semi-conducting substrate according to one of claims 3 to 6 wherein the first, second, third, fourth, fifth and sixth binary alloys are chosen from among AIN, GaN, BN, and InN.

8. Semi-conducting substrate according to one of the preceding claims, wherein the barrier layer further includes a layer of III-N semi-conducting ternary alloy.

9. Semi-conducting substrate according to claim 8, wherein the alternation of layers composed of at least one atomic monolayer of first and second III-N semi-conducting binary alloys is located between the support and said layer of III-N semi-conducting ternary alloy.

10. Semi-conducting substrate according to claim 8, wherein the barrier layer comprises a plurality of layers of III-N semi-conducting ternary alloy, each layer of III-N semi-conducting ternary alloy being located between a layer of the first binary alloy and a layer of the second binary alloy of the alternation.

11. Semi-conducting substrate according to claim 10, wherein the barrier layer further includes a layer of the III-N semi-conducting ternary alloy on the alternation of layers composed of at least one atomic monolayer of first and second III-N semi-conducting binary alloys.

12. Semi-conducting substrate according to claim 2, wherein the channel layer further comprises a plurality of layers of III-N semi-conducting ternary alloy, each layer of III-N semi-conducting ternary alloy being located between a layer of the third binary alloy and a layer of the fourth binary alloy of the alternation.

13. Semi-conducting substrate according to one of claims 9 to 12, wherein the number of atomic monolayers in each layer of the ternary alloy located between two layers of the binary alloys is comprised between 1 and 5.

14. Semi-conducting substrate according to claim 1 or 3, wherein the channel layer is made of a layer of ternary alloy of AlGaN, or InGaN, or AlBN, or InBN, or InAlN.

15. Semi-conducting substrate according to claim 1 or 3, wherein the channel layer is made of a layer of binary alloy of GaN, or AIN, or BN, or InN.

16. Semi-conducting substrate according to claim 1 or 2, wherein the semi-conducting substrate (60) further comprises a buffer layer (56) between the support (52) and the channel layer (51), the buffer layer being made of a layer of binary alloy of GaN, or AIN, or BN, or InN.

17. Semiconducting substrate according to claim 1 or 2, wherein the semi-conducting substrate (60) further comprises a buffer layer (56) between the support (52) and the channel layer (51), the buffer layer being made of a layer of ternary alloy of AlGaN, or InGaN, or AlBN, or InBN, or InAlN,

18. Semi-conducting substrate according to one of the preceding claims, wherein the support (52) is made of a material chosen from among Si, SIC, AIN, Sapphire, and GaN.

19. Semi-conducting substrate according to one of the preceding claims, wherein the thickness of the barrier layer (53) is comprised between 2 nm and 500 nm.

20. Method for preparation of a semi-conducting substrate (60) based on elements in column III in the periodic table and nitrogen comprising a support (52), a channel layer (51) on the support and a barrier layer (53) on the channel layer, wherein the method comprises the following step (no order being imposed):

   creation of an initial barrier layer by:

i) deposit of at least one atomic monolayer of a first III-N binary alloy, each atomic monolayer being composed of one monoatomic plane of III element and one monoatomic plane of nitrogen;

ii) deposit of at least one atomic monolayer of a second III-N binary alloy, each atomic monolayer being composed of one monoatomic plane of III element and one monoatomic plane of nitrogen;

iii) repetition of steps i) and ii) if necessary until the required thickness is obtained.

21. Method according to claim 20, wherein the method further comprises the step of creation of at least one layer of III-N ternary alloy in or on the initial barrier layer.

22. Method according to claim 21, wherein the step of creation of said layer of ternary alloy comprises the deposit of a layer of a ternary alloy.

23. Method according to claim 21, wherein the step of creation of said layer of ternary alloy comprises thermal treatment of atomic monolayers of first and second binary alloys deposited in i) and ii).

24. Method according to claim 23, wherein the thermal treatment is carried out after at least some deposits of the second binary alloy:

- at a surface temperature between 0°C and 300°C above to the temperature of creation of monolayers of first and second binary alloys;
- under vacuum, or ultra-high vacuum between $10^{-8}$ Torr and $10^{-1}$ Torr ;
- under a gas mixture flow comprising ammoniac NH3 or nitrogen molecule N2 or hydrogen molecule H2 a pressure comprised between $10^{-8}$ Torr and the pressure of 1 kBar;
- In presence of a $NH_3$, $N_2$ or $H_2$ plasma.

25. Method according to claim 23 or 24, wherein the thermal treatment of atomic monolayers of first and second binary alloys deposited in i) and ii) is made after the step of creation of the initial barrier layer.

26. Method according to one of claims 20 to 25, wherein the method further comprises the step of creation of a channel layer by deposit of a binary alloy of GaN, or AlN, or BN, or InN.

27. Method according to one of claim 20 to 25, wherein the method further comprises the step of creation of a channel layer by deposit of a ternary alloy of AlGaN, or InGaN, or AlBN, or InBN, or InAlN.

28. Method according to one of claims 20 to 25, wherein the method further comprises the step of creation of a channel layer by:

iv) deposit of an atomic monolayer of a third III-N binary alloy;
v) deposit of an atomic monolayer of a fourth III-N binary alloy;
vi) repetition of steps iv) and v) if necessary until the required thickness Is obtained.

29. Method according to claim 28, wherein the step of creation of a channel layer further comprises thermal treatment of atomic monolayers of third and fourth binary alloys deposited In iv) and v), the thermal treatment being carried out before some deposits of the fourth binary alloy:

- at a surface temperature between 0°C and 300°C above to the temperature of creation of monolayers of third and fourth binary alloys;
- under vacuum or ultra-high vacuum between $10^{-8}$ Torr and $10^{-1}$ Torr;
- under a gas mixture flow comprising ammoniac NH3 or nitrogen molecule N2 or hydrogen molecule H2 a pressure comprised between $10^{-8}$ Torr and the pressure of 1 kBar;
- In presence of a $NH_3$, $N_2$ or $H_2$ plasma.

30. Method according to one of claims 20 to 29, wherein the method further comprises the step of creation of a buffer layer by deposit of a binary alloy of GaN, or AlN, or BN, or InN.

EP 1 800 346 B1

**Patentansprüche**

1. Halbleitendes Substrat (60) basierend auf Elementen in den Spalten III im Periodensystem und auf Stickstoff zur Verwendung beispielsweise zum Herstellen von Transistorstrukturen vom HEMT-Typ, umfassend einen Träger (52), eine Kanalschicht (51) auf dem Träger und eine Barriereschicht (53) auf der Kanalschicht (51), wobei die Barriereschicht (53) aus einer alternierenden Abfolge von Schichten, gebildet aus mindestens einer atomaren Monoschicht von ersten und zweiten binären halbleitenden III-N-Legierungen (54, 55), wobei jede atomare Monoschicht aus einer monoatomaren Ebene von III-Element und einer monoatomaren Ebene von Stickstoff gebildet wird, gebildet wird.

2. Halbleitendes Substrat nach Anspruch 1, wobei die Kanalschicht eine alternierende Abfolge von Schichten, welche aus mindestens einer atomaren Monoschicht von dritten und vierten binären halbleitenden III-N-Legierungen gebildet werden, umfasst.

3. Halbleitendes Substrat nach Anspruch 1 oder 2, wobei das halbleitende Substrat (60) des Weiteren eine Pufferschicht (56) zwischen dem Träger (52) und der Kanalschicht (51) umfasst, wobei die Pufferschicht (56) eine alternierende Abfolge von Schichten, welche aus mindestens einer atomaren Monoschicht von fünften und sechsten binären halbleitenden III-N-Legierungen gebildet werden, umfasst.

4. Halbleitendes Substrat nach Anspruch 1, 2 oder 3, wobei die Anzahl von atomaren Monoschichten in jeder binären Legierung der alternierenden Abfolge der Barriereschicht oder der Kanalschicht oder der Pufferschicht zwischen 1 und 20 eingeschlossen liegt.

5. Halbleitendes Substrat nach Anspruch 1 oder 2 oder 3, wobei die Anzahl von atomaren Monoschichten in jeder binären Legierung der alternierenden Abfolge der Barriereschicht oder der Kanalschicht oder der Pufferschicht zwischen einem ersten Wert auf einer Rückseite der Barriereschicht oder der Kanalschicht oder der Pufferschicht und einem zweiten Wert auf einer Vorderseite der Barriereschicht oder der Kanalschicht oder der Pufferschicht variiert, wobei die Rückseite dem Träger (52) näher liegt als die Vorderseite.

6. Halbleitendes Substrat nach Anspruch 5, wobei die ersten und zweiten Werte zwischen 1 und 20 eingeschlossen liegen.

7. Halbleitendes Substrat nach einem der Ansprüche 3 bis 6, wobei die ersten, zweiten, dritten, vierten, fünften und sechsten binären Legierungen aus AIN, GeN, BN und InN ausgewählt sind.

8. Halbleitendes Substrat nach einem der vorangegangenen Ansprüche, wobei die Barriereschicht des Weiteren eine Schicht einer halbleitenden ternären III-N-Legierung umfasst.

9. Halbleitendes Substrat nach Anspruch 8, wobei die alternierende Abfolge von Schichten, welche aus mindestens einer atomaren Monoschicht von ersten und zweiten halbleitenden binären III-N-Legierungen gebildet werden, sich zwischen dem Träger und der Schicht der halbleitenden ternären III-N-Legierung befindet.

10. Halbleitendes Substrat nach Anspruch 8, wobei die Barriereschicht eine Mehrzahl von Schichten von halbleitender ternärer III-N-Legierung umfasst, wobei jede Schicht von halbleitender ternärer III-N-Legierung sich zwischen einer Schicht der ersten binären Legierung und einer Schicht der zweiten binären Legierung der alternierenden Abfolge befindet.

11. Halbleitendes Substrat nach Anspruch 10, wobei die Barriereschicht des Weiteren eine Schicht der halbleitenden ternären III-N-Legierung auf der alternierenden Abfolge von Schichten, die aus mindestens einer atomaren Monoschicht von ersten und zweiten halbleitenden binären III-N-Legierungen gebildet werden, umfasst.

12. Halbleitendes Substrat nach Anspruch 2, wobei die Kanalschicht des Weiteren eine Mehrzahl von Schichten von halbleitender ternärer III-N-Legierung umfasst, wobei jede Schicht von halbleitender ternärer III-N-Legierung sich zwischen einer Schicht der dritten binären Legierung und einer Schicht der vierten binären Legierung der alternierenden Abfolge befindet.

13. Halbleitendes Substrat nach einem der Ansprüche 9 bis 12, wobei die Anzahl von atomaren Monoschichten in jeder Schicht der ternären Legierung, die sich zwischen zwei Schichten der binären Legierungen befindet, zwischen 1

19

und 5 eingeschlossen liegt.

14. Halbleitendes Substrat nach Anspruch 1 oder 3, wobei die Kanalschicht aus einer Schicht einer ternären Legierung von AlGaN oder InGaN oder AlBN oder InBN oder InAlN hergestellt ist.

15. Halbleitendes Substrat nach Anspruch 1 oder 3, wobei die Kanalschicht aus einer Schicht einer binären Legierung von GaN oder AlN oder BN oder InN hergestellt ist.

16. Halbleitendes Substrat nach Anspruch 1 oder 2, wobei das halbleitende Substrat (60) des Weiteren eine Pufferschicht (56) zwischen dem Träger (52) und der Kanalschicht (51) umfasst, wobei die Pufferschicht aus einer Schicht einer binären Legierung von GaN oder AlN oder BN oder InN hergestellt ist.

17. Halbleitendes Substrat nach Anspruch 1 oder 2, wobei das halbleitende Substrat (60) des Weiteren eine Pufferschicht (56) zwischen dem Träger (52) und der Kanalschicht (51) umfasst, wobei die Pufferschicht aus einer Schicht einer ternären Legierung von AlGaN oder InGaN oder AlBN oder InBN oder InAlN hergestellt ist.

18. Halbleitendes Substrat nach einem der vorangegangenen Ansprüche, wobei der Träger (52) aus einem aus Si, SiC, AlN, Saphir und GaN ausgewählten Material hergestellt ist.

19. Halbleitendes Substrat nach einem der vorangegangenen Ansprüche, wobei die Dicke der Barriereschicht (53) zwischen 2 nm und 500 nm eingeschlossen liegt.

20. Verfahren zur Herstellung eines halbleitenden Substrats (60) basierend auf Elementen in den Spalten III im Periodensystem und auf Stickstoff, umfassend einen Träger (52), eine Kanalschicht (51) auf dem Träger und eine Barriereschicht (53) auf der Kanalschicht, wobei das Verfahren den folgenden Schritt umfasst (wobei keinerlei Reihenfolge festgelegt wird):

    Erzeugung einer anfänglichen Barriereschicht durch:

    i) Abscheidung von mindestens einer atomaren Monoschicht einer ersten binären III-N-Legierung, wobei jede atomare Monoschicht aus einer monoatomaren Ebene von III-Element und einer monoatomaren Ebene von Stickstoff gebildet wird;
    ii) Abscheidung von mindestens einer atomaren Monoschicht einer zweiten binären III-N-Legierung, wobei jede atomare Monoschicht aus einer monoatomaren Ebene von III-Element und einer monoatomaren Ebene von Stickstoff gebildet wird;
    iii) Wiederholung der Schritte i) und ii), sofern erforderlich, bis die benötigte Dicke erhalten wird.

21. Verfahren nach Anspruch 20, wobei das Verfahren des Weiteren den Schritt einer Erzeugung von mindestens einer Schicht von ternärer III-N-Legierung in oder auf der anfänglichen Barriereschicht umfasst.

22. Verfahren nach Anspruch 21, wobei der Schritt einer Erzeugung der Schicht von ternärer Legierung die Abscheidung einer Schicht einer ternären Legierung umfasst.

23. Verfahren nach Anspruch 21, wobei der Schritt einer Erzeugung der Schicht von ternärer Legierung eine thermische Behandlung von atomaren Monoschichten von ersten und zweiten binären Legierungen, die in i) und ii) abgeschieden worden sind, umfasst.

24. Verfahren nach Anspruch 23, wobei die thermische Behandlung nach mindestens einigen Abscheidungen der zweiten binären Legierung ausgeführt wird:

    - bei einer Oberflächentemperatur zwischen 0°C und 300°C oberhalb der Temperatur der Erzeugung von Monoschichten von ersten und zweiten binären Legierungen:
    - unter Vakuum oder Ultrahochvakuum zwischen $10^{-8}$ Torr und $10^{-1}$ Torr;
    - unter einem Gasmischungsstrom, umfassend Ammoniak $NH_3$ oder Stickstoffmoleküle $N_2$ oder Wasserstoffmoleküle $H_2$, wobei ein Druck zwischen $10^{-8}$ Torr und dem Druck von 1 kBar eingeschlossen liegt;
    - in Gegenwart eines $NH_3$-, $N_2$- oder $H_2$-Plasmas.

25. Verfahren nach Anspruch 23 oder 24, wobei die thermische Behandlung von atomaren Monoschichten von ersten und zweiten binären Legierungen, die in i) und ii) abgeschieden worden sind, nach dem Schritt einer Erzeugung der anfänglichen Barriereschicht vorgenommen wird.

26. Verfahren nach einem der Ansprüche 20 bis 25, wobei das Verfahren des Weiteren den Schritt einer Erzeugung einer Kanalschicht durch Abscheidung einer binären Legierung von GaN oder AIN oder BN oder InN umfasst.

27. Verfahren nach einem der Ansprüche 20 bis 25, wobei das Verfahren des Weiteren den Schritt einer Erzeugung einer Kanalschicht durch Abscheidung einer ternären Legierung von AlGaN oder InGaN oder AIBN oder InBN oder InAlN umfasst.

28. Verfahren nach einem der Ansprüche 20 bis 25, wobei das Verfahren des Weiteren den Schritt einer Erzeugung einer Kanalschicht durch:

iv) Abscheidung einer atomaren Monoschicht einer dritten binären III-N-Legierung;
v) Abscheidung einer atomaren Monoschicht einer vierten binären III-N-Legierung;
vi) Wiederholung der Schritte iv) und v), sofern erforderlich, bis die benötigte Dicke erhalten wird, umfasst.

29. Verfahren nach Anspruch 28, wobei der Schritt einer Erzeugung einer Kanalschicht des Weiteren eine thermische Behandlung von atomaren Monoschichten von dritten und vierten binären Legierungen, die in iv) und v) abgeschieden worden sind, umfasst, wobei die thermische Behandlung vor einigen Abscheidungen der vierten binären Legierung ausgeführt wird:

- bei einer Oberflächentemperatur zwischen 0°C und 300°C oberhalb der Temperatur der Erzeugung von Monoschichten von dritten und vierten binären Legierungen:
- unter Vakuum oder Ultrahochvakuum zwischen $10^{-8}$ Torr und $10^{-1}$ Torr;
- unter einem Gasmischungsstrom, umfassend Ammoniak $NH_3$ oder Stickstoffmoleküle $N_2$ oder Wasserstoffmoleküle $H_2$, wobei ein Druck zwischen $10^{-8}$ Torr und dem Druck von 1 kBar eingeschlossen liegt;
- in Gegenwart eines $NH_3$-, $N_2$- oder $H_2$-Plasmas.

30. Verfahren nach einem der Ansprüche 20 bis 29, wobei das Verfahren des Weiteren den Schritt einer Erzeugung einer Pufferschicht durch Abscheidung einer binären Legierung von GaN oder AIN oder BN oder InN umfasst.

**Revendications**

1. Substrat semi-conducteur (60) à base d'éléments de la colonne III dans le tableau périodique et d'azote, destiné par exemple à fabriquer des structures de transistor de type HEMT, comprenant un support (52), une couche canal (51) sur le support et une couche barrière (53) sur la couche canal, où la couche barrière (53) est composée d'une alternance de couches composées d'au moins une monocouche atomique de premier et second alliages semi-conducteurs binaires III-N (54, 55), chaque monocouche atomique étant composée d'un plan monoatomique d'élément III et d'un plan monoatomique d'azote.

2. Substrat semi-conducteur selon la revendication 1, dans lequel la couche canal comprend une alternance de couches composées d'au moins une monocouche atomique de troisième et quatrième alliages semi-conducteurs binaires III-N.

3. Substrat semi-conducteur selon la revendication 1 ou 2, dans lequel le substrat semi-conducteur (60) inclut en outre une couche tampon (56) entre le support (52) et la couche canal (51), la couche tampon (56) comprenant une alternance de couches composées d'au moins une monocouche atomique de cinquième et sixième alliages semi-conducteurs binaires III-N.

4. Substrat semi-conducteur selon la revendication 1, 2 ou 3, dans lequel le nombre de monocouches atomiques dans chaque alliage binaire de l'alternance de la couche barrière ou de la couche canal ou de la couche tampon est compris entre 1 et 20.

5. Substrat semi-conducteur selon la revendication 1, 2 ou 3, dans lequel le nombre de monocouches atomiques dans chaque alliage binaire de l'alternance de la couche barrière ou de la couche canal ou de la couche tampon varie entre une première valeur sur une face arrière de la couche barrière ou de la couche canal ou de la couche tampon, et une seconde valeur sur une face avant de la couche barrière ou de la couche canal ou de la couche tampon, la face arrière étant plus proche du support (52) que la face avant.

6. Substrat semi-conducteur selon la revendication 5, dans lequel les première et seconde valeurs sont comprises entre 1 et 20.

7. Substrat semi-conducteur selon l'une des revendications 3 à 6, dans lequel les premier, deuxième, troisième, quatrième, cinquième et sixième alliages binaires sont choisis parmi AIN, GaN, BN et InN.

8. Substrat semi-conducteur selon l'une quelconque des revendications précédentes, dans lequel la couche barrière inclut en outre une couche d'alliage ternaire semi-conducteur III-N.

9. Substrat semi-conducteur selon la revendication 8, dans lequel l'alternance de couches composées d'au moins une monocouche atomique de premier et second alliages binaires semi-conducteurs III-N est située entre le support et ladite couche d'alliage ternaire semi-conducteur III-N.

10. Substrat semi-conducteur selon la revendication 8, dans lequel la couche de barrière comprend une pluralité de couches d'alliage ternaire semi-conducteur III-N, chaque couche d'alliage ternaire semi-conducteur III-N étant située entre une couche du premier alliage binaire et une couche du second alliage binaire de l'alternance.

11. Substrat semi-conducteur selon la revendication 10, dans lequel la couche de barrière inclut en outre une couche de l'alliage ternaire semi-conducteur III-N sur l'alternance de couches composées d'au moins une monocouche atomique de premier et second alliages binaires semi-conducteurs III-N.

12. Substrat semi-conducteur selon la revendication 2, dans lequel la couche de canal comprend en outre une pluralité de couches d'alliage ternaire semi-conducteur III-N, chaque couche d'alliage ternaire semi-conducteur III-N étant située entre une couche du troisième alliage binaire et une couche du quatrième alliage binaire de l'alternance.

13. Substrat semi-conducteur selon l'une des revendications 9 à 12, dans lequel le nombre de monocouches atomiques dans chaque couche de l'alliage ternaire située entre deux couches des alliages binaires est compris entre 1 et 5.

14. Substrat semi-conducteur selon la revendication 1 ou 3, dans lequel la couche canal est constituée d'une couche d'alliage ternaire de AIGaN, ou InGaN, ou AIBN, ou InBN ou InAIN.

15. Substrat semi-conducteur selon la revendication 1 ou 3, dans lequel la couche canal est constituée d'une couche d'alliage binaire de GaN, ou AIN, ou BN ou InN.

16. Substrat semi-conducteur selon la revendication 1 ou 2, dans lequel le substrat semi-conducteur (60) comprend en outre une couche tampon (56) entre le support (52) et la couche canal (51), la couche tampon étant constituée d'une couche d'alliage binaire de GaN, ou AIN, ou BN ou InN.

17. Substrat semi-conducteur selon la revendication 1 ou 2, dans lequel le substrat semi-conducteur (60) comprend en outre une couche tampon (56) entre le support (52) et la couche canal (51), la couche tampon étant constituée d'une couche d'alliage ternaire de AIGaN, ou InGaN, ou AIBN, ou InBN ou InAIN.

18. Substrat semi-conducteur selon l'une des revendications précédentes, dans lequel le support (52) est constitué d'un matériau choisi parmi Si, SiC, AIN, saphir et GaN.

19. Substrat semi-conducteur selon l'une des revendications précédentes, dans lequel l'épaisseur de la couche barrière (53) est comprise entre 2 nm et 500 nm.

20. Méthode de préparation d'un substrat semi-conducteur (60) à base d'éléments de la colonne III dans le tableau périodique et d'azote, comprenant un support (52), une couche canal (51) sur le support et une couche barrière (53) sur la couche canal, où la méthode comprend les étapes suivantes (aucun ordre n'est imposé) :

création d'une couche barrière initiale par :

i) dépôt d'au moins une monocouche atomique d'un premier alliage binaire III-N, chaque monocouche atomique étant composée d'un plan monoatomique d'élément III et d'un plan monoatomique d'azote ;
ii) dépôt d'au moins une monocouche atomique d'un second alliage binaire III-N, chaque monocouche atomique étant composée d'un plan monoatomique d'élément III et d'un plan monoatomique d'azote ;
iii) répétition des étapes i) et ii) si nécessaire jusqu'à obtention de l'épaisseur requise.

21. Méthode selon la revendication 20, dans laquelle la méthode comprend en outre l'étape de création d'au moins une couche d'alliage ternaire III-N dans ou sur la couche barrière initiale.

22. Méthode selon la revendication 21, dans laquelle l'étape de création de ladite couche d'alliage ternaire comprend le dépôt d'une couche d'un alliage ternaire.

23. Méthode selon la revendication 21, dans laquelle l'étape de création de ladite couche d'alliage ternaire comprend le traitement thermique de monocouches atomiques des premier et second alliages binaires déposées en i) et ii).

24. Méthode selon la revendication 23, dans laquelle le traitement thermique est réalisé après au moins certains dépôts du second alliage binaire :

- à une température de surface comprise entre 0 °C et 300 °C au-dessus de la température de création des monocouches de premier et second alliages binaires ;
- sous vide, ou sous un vide ultraélevé entre $10^{-8}$ Torr et $10^{-1}$ Torr ;
- sous un flux de mélange gazeux comprenant de l'ammoniac $NH_3$ ou de l'azote moléculaire $N_2$ ou de l'hydrogène moléculaire $H_2$ à une pression comprise entre $10^{-8}$ Torr et la pression de 1 kBar ;
- en présence de plasma à $NH_3$, $N_2$ ou $H_2$.

25. Méthode selon la revendication 23 ou 24, dans laquelle le traitement thermique de monocouches atomiques des premier et second alliages binaires déposées en i) et ii) est effectué après l'étape de création de la couche barrière initiale.

26. Méthode selon l'une des revendications 20 à 25, dans laquelle la méthode comprend en outre l'étape de création d'une couche de canal par dépôt d'un alliage binaire de GaN, ou AlN, ou BN ou InN.

27. Méthode selon l'une des revendications 20 à 25, dans laquelle la méthode comprend en outre l'étape de création d'une couche de canal par dépôt d'un alliage ternaire de AlGaN, ou InGaN, ou AlBN, ou InBN ou InAlN.

28. Méthode selon l'une des revendications 20 à 25, dans laquelle la méthode comprend en outre l'étape de création d'une couche de canal par :

iv) dépôt d'une monocouche atomique d'un troisième alliage binaire III-N ;
v) dépôt d'une monocouche atomique d'un quatrième alliage binaire III-N ;
vi) répétition des étapes iv) et v) si nécessaire jusqu'à obtention de l'épaisseur requise.

29. Méthode selon la revendication 28, dans laquelle l'étape de création d'une couche de canal comprend en outre un traitement thermique de monocouches atomiques des troisième et quatrième alliages binaires déposées en iv) et v), le traitement thermique étant réalisé avant certains dépôts du quatrième alliage binaire ;

- à une température de surface comprise entre 0 °C et 300 °C au-dessus de la température de création des monocouches de premier et second alliages binaires ;
- sous vide, ou sous un vide ultraélevé entre $10^{-8}$ Torr et $10^{-1}$ Torr ;
- sous un flux de mélange gazeux comprenant de l'ammoniac $NH_3$ ou de l'azote moléculaire $N_2$ ou de l'hydrogène moléculaire $H_2$ à une pression comprise entre $10^{-8}$ Torr et la pression de 1 kBar ;
- en présence de plasma à $NH_3$, $N_2$ ou $H_2$.

30. Méthode selon l'une des revendications 20 à 29, dans laquelle la méthode comprend en outre l'étape de création d'une couche tampon par dépôt d'un alliage binaire de GaN, ou AlN, ou BN ou InN.

FIG.1

1    face Ga, Al             [000$\bar{1}$]

$P_{SP}$   $P_{PE}$    AlGaN

6          Tension

σ                   4

$P_{SP}$       GaN

            Relaxé     3

5        Substrat      2

## FIG.2

## FIG.3

30

31

32

FIG.4

33    34

36

35

FIG.5a          FIG.5b

## FIG.6a

## FIG.6b

## FIG.6c

FIG.7a

FIG.7b

54''''

55''

54''

55'

53

54'

51

52

## FIG.7c

55

54

55

53

54

55

54

55

54

51

58

56

57

58

52

57

## FIG.7d

Ga x 4

Al x 2

# FIG.8a

53 — 80
55
54
55
54
55
54

51

52

## FIG.7E

55
70
54
70
55
70
53 — 54
70
55
70
54

51

52

## FIG.7F

FIG.7G

FIG.9

FIG.10

## FIG.8b

## FIG.11

L594 (SP3 49,2% prep substrat HF+CARO+Ozone)

FIG_12A

Peak  Surface Area  Summit  Zero Crossing  Stopband  Execute  Cursor

Roughness Analysis

FIG_12B

Image Statistics

| | |
|---|---|
| Img. Z range | 19.070 nm |
| Img. Rms (Rq) | 2.908 nm |
| Img. Ra | 2.336 nm |

Box Statistics

Z range
Rms (Rq)
Mean roughness (Ra)
Av max ht (Rpm)
Area Thresh(%rms)
Box x dimension
Box y dimension

1593.5m

Peak Off        Summit Off        Zero Cross. Off Box Cursor

## L594 (SP3 66,9% prep substrat HF+CARO)

FIG_12C

Peak   Surface Area   Summit   Zero Crossing   Stopband   Execute   Cursor

Roughness Analysis

FIG_12D

Image Statistics

| | | |
|---|---|---|
| Img. Z range | 23.101 | nm |
| Img. RMS (Rq) | 3.463 | nm |
| Img. Ra | 2.766 | nm |

Box Statistics

Z range
RMS (Rq)
Mean roughness (Ra)
Av max ht (Rpm)
Area Thresh(%rms)
Box x dimension
Box y dimension

1594.5m

Peak Off       Summit Off       Zero Cross. Off  Box Cursor

Sample a)

SP3 structure with **20%** Al in the barrier

**FIG.12E**

0                    2.00 µм

Sample b)

SP3 structure with **25%** Al in the barrier

**FIG.12F**

2.00

0

0                    2.00µм

Sample c)

SP3 structure with **32%** Al in the barrier

## FIG.12G

0      2.00 µM

Sample d)

SP3 structure with **40%** Al in the barrier

## FIG.12H

0      2.00 µM

2.00  Sample e)

P-SP3 structure with 39%
Al in the barrier

FIG.12I

0

2.00 μM

| 7 | | GaN Cap | | 2 nm | | 650 |
|---|---|---|---|---|---|---|
| 6 | | AlGaN Schottky layer | | 4 nm | 25% | 640 |
| 4 | | AlGaN Barrier | | 11 nm | 50% | 630 |
| 3 | | GaN channel | | 15 nm | | 620 |
| 2 | | AlGaN template | | 1500 nm | 10% | 610 |
| 1 | | PICOGIGA Buffer | | 500 nm | | 600 |

FIG.13

A   B   A   B ...        A C B C A C B C A ...

730

| GaN cap | |
| AlGaN 25%          ( 10 nm ) | |
| C | }  X8 |
| Daz electrons | |
| GaN  buffer | |

710

720

| GaN cap | |
| AlGaN 25%          ( 4 nm ) | |
| C | |
| B | |
| B | }  X10 |
| C | |
| A | |
| Daz electrons | |
| GaN  buffer | |

FIG. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 02093650 A
- WO 002093650 A
- US 6100542 A
- WO 0209365 A

### Non-patent literature cited in the description

- **K. Asano ; Y. Miyoshi ; K. Ishikura ; Y. Nashimoto ; M. Kuzuhara ; M. Mizuta.** *IEDM,* 1998, 59
- **R.A. Sadler ; S.T. Allen ; T.S. Alcorn ; W.L. Pribble ; J. Surnakeris ; J.W. Palmour.** *56th Device Research Council,* 1998, 92
- **S.T. Sheppard ; K. Doverspike ; W.L. Pribble ; S.T. Allen ; J.W. Palmour ; L.T. Kehias ; T.J. Jenkins.** *IEEE Elec. Dev. Lett.,* 1999, vol. 20, 161
- **H.M. Ng. ; D. Doppalapudi ; T.D. Moustakas ; N.G. Weimann ; L.F. Eastman.** *Appl. Phys. Lett.,* 1998, vol. 73, 821
- **S. Keller ; G. Parish ; P.T. Fini ; S. Heikman ; C.H. Chen ; N. Zhang ; S.P. DenBaars ; U.K. Mishra.** *J. Appl. Phys.,* 1999, vol. 86, 5850
- **I.P. Smorchkova ; C.R. Elsass ; J.P. Ibbetson ; R. Vetury ; B. Heying ; P. Fini ; E. Haus ; S.P. DenBaars ; J.S. Speck ; U.K. Mishra.** *J. Appl. Phys.,* 1999, vol. 86, 4520
- Modulation doped AlGaAs/GaAs heterostructures. **H. Morkoc.** The Technology and physics of molecular beam epitaxy. Plenium press, 1985
- **O. Ambacher ; J. Smart ; J.R. Shealy ; N.G. Weinmann ; K. Chu ; M. Murphy ; W.J. Schaff ; L.F. Eastman ; R. Dimitrov ; L. Wittmer.** *J. Appl. Phys.,* 1999, vol. 85, 3222
- **F. Bernardini ; V. Fiorentini ; D. Vanderbilt.** *Phys. Rev. B,* 1997, vol. 56, R10024